# EUROPEAN PATENT SPECIFICATION

(11) **EP 3 436 963 B1**
(45) Date of publication and mention of the grant of the patent: **24.08.2022**
(21) Application number: 17776252.3
(22) Date of filing: 06.03.2017
(51) Int. Cl.: G06F 13/16, G06F 13/40, G11C 5/04, G11C 5/06, G11C 7/10, G11C 11/4093

(54) **MEMORY SUBSYSTEM WITH NARROW BANDWIDTH REPEATER CHANNEL**
SPEICHERSUBSYSTEM MIT SCHMALBANDIGEM REPEATER-KANAL
SOUS-SYSTÈME DE MÉMOIRE À CANAL RÉPÉTEUR DE LARGEUR DE BANDE ÉTROITE

(30) Priority: 01.04.2016 US 201615089453
(43) Date of publication of application: 06.02.2019
(73) Proprietor: Intel Corporation, Santa Clara, CA 95054 (US)
(72) Inventor: VOGT, Pete, Boulder Colorado 80303 (US)
(74) Representative: Rummler, Felix
(86) International application number: PCT/US2017/021003
(87) International publication number: WO 2017/172285

(56) References cited:
- WO-A1-2007/106830
- WO-A1-2007/135077
- WO-A1-2015/065310
- WO-A2-2011/081691
- US-A1- 2006 288 132
- US-A1- 2008 077 731
- US-A1- 2009 193 201
- US-A1- 2009 319 719
- Bruce Jacob: "Memory Systems: Cache, DRAM, Disk, C", , 29 October 2007 (2007-10-29), pages 554-575, XP055466438, Retrieved from the Internet: URL:https://www.e-reading.club/bookreader. php/138837/Jacob,_Ng,_Wang_-_Memory_system s._Cache,_DRAM,_Disk.pdf [retrieved on 2018-04-11]

## Description

### RELATED APPLICATIONS

This application claims priority under 35 U.S.C. § 365(c) to US Application No. 15/089,456 filed on April 1, 2016, entitled: "MEMORY SUBSYSTEM WITH NARROW BANDWIDTH REPEATER CHANNEL." The present application is related to U.S. Patent Application No. 15/089,454 entitled: "WRITE DELIVERY FOR MEMORY SUBSYSTEM WITH NARROW BANDWIDTH REPEATER CHANNEL," and U.S. Patent Application No. 15,089,455 entitled: "MEMORY SUBSYSTEM WITH NARROW BANDWIDTH REPEATER CHANNEL," both filed April 1, 2016.

### FIELD

The descriptions are generally related to memory channels, and more particular descriptions are related to a narrow bandwidth backend channel from a channel repeater.

### COPYRIGHT NOTICE/PERMISSION

Portions of the disclosure of this patent document may contain material that is subject to copyright protection. The copyright owner has no objection to the reproduction by anyone of the patent document or the patent disclosure as it appears in the Patent and Trademark Office patent file or records, but otherwise reserves all copyright rights whatsoever. The copyright notice applies to all data as described below, and in the accompanying drawings hereto, as well as to any software described below: Copyright ^{©} 2016, Intel Corporation, All Rights Reserved.

### BACKGROUND

With ever-improving designs and manufacturing capability, processors continue to become more capable and achieve higher performance. As their capabilities increase, the demand for more functionality from devices increases. The increased functionality in turn increases processor bandwidth demand. The processor bandwidth demand is related to higher overall data throughput. Thus, the inability to move data into and out of the processor with higher bandwidths can impede the continuation of processor performance improvements.

Modern computing systems include on die memory storage, or cache which the processor can access relatively quickly, and main memory that has higher capacity but takes longer to access. Higher processor throughput means the desire for memory continues to increase, and systems incorporate more and more main memory capacity. Traditional connection of the main memory to the processor is via native memory channels. Native memory channels rely on a direct connection from the memory devices to a controller circuit or memory manager/driver on the host processor. Thus, traditional memory connection occurs through multidrop channels, where the signal lines of a memory channel extend from devices mounted physically closest to the processor to the devices mounted physically farthest from the processor. The devices connect in turn and drive the same signal lines.

Multidrop channels limit the number of memory devices that can be connected to a processor, which limits the memory capacity of a system. When more memory devices and memory modules are connected with native connections, the loading on the memory channel can degrade the communication over the bus. Thus, there is a tradeoff between increasing the speed and increasing the capacity in a memory subsystem. The tradeoff represents a potential limitation in the ability of memory bandwidth to continue to scale to processor performance. Current systems are already hitting the data rate limit for a native multidrop memory channel with two memory modules installed. While increasing the number of channels can help with the data rate problem, it is also not scalable with processor performance increases. Increasing channel bandwidth may also be impractical because of increasing the number of signal lines, as well as increasing device and connector size to accommodate the additional signal lines.

WO-2007-135077 discloses memory systems that include a memory controller and an outbound link with the memory controller connected to the outbound link. The outbound link typically includes a number of conductive pathways that conduct memory signals from the memory controller to memory buffer devices in a first memory layer; and at least two memory buffer devices in a first memory layer. Each memory buffer device in the first memory layer typically is connected to the outbound link to receive memory signals from the memory controller.

WO-2007-106830 relates to systems, methods, and apparatuses for an input/output agent having multiple secondary ports. In some embodiments, the input/output agent includes a primary port to communicate data with an upstream agent over a serial point-to-point interconnect. The input/output agent may also include M secondary ports to communicate data with a corresponding M downstream agents, wherein downstream data is forwarded from the primary port to at least one of the M secondary ports. This document discloses the preamble of the independent claims.

"Memory Systems: Cache, DRAM, Disk, C" by Bruce Jacob et al., (20071029), pages 554 - 575 (URL: https://www.e-reading.club/bookreader.php/138837/Jacob,_Ng,_Wang_-_Memory_systems._Cache,_DRAM,_Disk.pdf, (20180411), XP055466438 [A] 1,12) describes fully buffered DIMM memory systems replacing the conventional memory system bus topology with a narrow, point-to-point interface between the memory controller and the memory modules.

WO-2011-081691 discloses an expandable memory system that enables a fixed signaling bandwidth to be configurably re-allocated among dedicated memory channels. Memory channels having progressively reduced widths are dedicated to respective memory sockets, thus enabling point-to-point signaling with respect to each memory socket without signal-compromising traversal of unloaded sockets or costly replication of a full-width memory channel for each socket.

### SUMMARY OF THE INVENTION

The invention is set out in the appended set of claims.

### BRIEF DESCRIPTION OF THE DRAWINGS

The following description includes discussion of figures having illustrations given by way of example of implementations of embodiments of the invention. The drawings should be understood by way of example, and not by way of limitation. As used herein, references to one or more "embodiments" are to be understood as describing a particular feature, structure, and/or characteristic included in at least one implementation of the invention. Thus, phrases such as "in one embodiment" or "in an alternate embodiment" appearing herein describe various embodiments and implementations of the invention, and do not necessarily all refer to the same embodiment. However, they are also not necessarily mutually exclusive.
Figure 1 is a block diagram of an embodiment of a system with a repeater channel architecture having a lower bandwidth repeater channel to extend the memory channel to another memory module.
Figure 2A is a block diagram of an embodiment of a system with a repeater channel architecture in which dual data rate (DDR) modules occupy both primary and secondary positions on the lower bandwidth repeated channel.
Figure 2B is a block diagram of an embodiment of a system with a repeater channel architecture in which a dual data rate (DDR) module occupies a primary position and a nonvolatile memory occupies a secondary position on the lower bandwidth repeated channel.
**Figure 3A** is a block diagram of an embodiment of a system with a repeater channel architecture in which both primary and secondary memory modules include a buffer.
**Figure 3B** is a block diagram of an embodiment of a system with a repeater channel architecture in which a primary memory module includes a buffer that supports a secondary channel, and a secondary memory module includes a buffer that does not support a secondary channel.
**Figure 4A** is a block diagram of an embodiment of a system with a repeater channel architecture illustrating primary and secondary channel connections for a single primary channel on a memory module.
**Figure 4B** is a block diagram of an embodiment of a system with a repeater channel architecture illustrating primary and secondary channel connections for first and second channels of a memory module.
**Figure 4C** is a block diagram of an embodiment of a system with a repeater channel architecture illustrating differential signaling for the primary and secondary channel connections.
**Figure 5** is a block diagram of an embodiment of a system in which a memory controller schedules commands for a repeater channel architecture having primary and secondary channel segments of different bandwidth.
**Figure 6** is a block diagram of an embodiment of a timing representation for a repeater channel architecture in which primary and secondary channel segments have different bandwidths.
**Figure 7** is a flow diagram of an embodiment of a process for accessing data in a repeated channel architecture with primary channel and secondary channel segments having different bandwidths.
**Figure 8** is a flow diagram of an embodiment of a process for setting up a memory module in a system with a repeated channel architecture with primary channel and secondary channel segments having different bandwidths.
**Figure 9** is a block diagram of an embodiment of a computing system in which a repeated memory channel architecture can be implemented.
**Figure 10** is a block diagram of an embodiment of a mobile device in which a repeated memory channel architecture can be implemented.

Descriptions of certain details and implementations follow, including a description of the figures, which may depict some or all of the embodiments described below, as well as discussing other potential embodiments or implementations of the inventive concepts presented herein.

### DETAILED DESCRIPTION

As described herein, a system with memory includes a repeater architecture where memory connects to a host with one bandwidth, and repeats the channel with a lower bandwidth. Instead of a multidrop memory channel, such a system can employ a point-to-point memory channel. Whereas a multidrop memory channel has all memory devices or memory modules loading the same signal lines that couple directly to the host, a point-to-point memory channel introduces a buffer that repeats the channel. The buffer can result in the host seeing the loading of only a single connection, while the channel can be extended through the repeating to additional devices.

As described herein, a memory circuit includes a first group of signal lines to couple point-to-point between a first group of memory devices and a host device. The memory circuit includes a second group of signal lines to couple point-to-point between the first group of memory devices and a second group of memory devices. The second group of signal lines extends the memory channel to the second group of memory devices. The second group of signal lines includes fewer data signal lines than the first group of signal lines, to support a lower bandwidth than the first group of signal lines on the memory channel. Thus, a repeater or a buffer architecture can convert a multidrop connection into a point-to-point connection. The point-to-point connection can enable higher data rates, due to the decrease of capacitive loading that would otherwise degrade high-speed communication on the connection.

In one embodiment, a memory subsystem includes point-to-point channels to connect the memory modules to a central processing unit (CPU). A point-to-point channel can scale to much higher data rates than a multidrop channel traditionally used in memory standards. In one embodiment, the memory subsystem supports the connection of two memory modules per channel to a CPU, with a point-to-point channel connected between the CPU and the first module, and a repeater on the first memory module to provide a second point-to-point channel to the second module. In some descriptions, the connection can be described as a first point-to-point channel and a second point-to-point channel, or a primary channel and a secondary channel, or some other description. It will be understood that such descriptions are for purposes of illustration and refer to a memory channel that is repeated. Thus, reference to a second channel or a secondary channel can be understood as referring to a second portion of the memory channel or a secondary portion of the memory channel. Thus, a single memory channel can be considered to be separated into a first channel and an extension channel, or to be considered to be treated as separate sub-channels of the memory channel.

With the repeater channel architecture, the extended or repeated point-to-point channel is narrower than the first portion of the channel. More specifically, the second portion of the channel extending from a buffer or repeater has fewer signals lines than the portion of the channel between the host and the first point-to-point connection. By sharing the bandwidth to the CPU between a pair of memory modules, the second memory module can operate on a narrower channel to deliver requested bandwidth.

Reference is made throughout to sharing bandwidth between a first memory module and a second memory module. For purposes of simplicity in description, examples and embodiments are described with respect to a secondary channel having half the bandwidth of the primary channel. Such descriptions will be understood as non-limiting examples. While certain implementations can share half the bandwidth on a repeated channel, other implementations can share other portions of the bandwidth. As one example, the secondary channel could be allocated a third of the bandwidth, such as by alternating packets to/from the secondary memory module where every third memory access packet is allocated to the secondary memory module. It will be understood that other divisions and other portions of the memory channel could be shared in accordance with what is described herein. One of skill in the art will understand how to modify the system to share a portion of the bandwidth other than one half.

Furthermore, reference is made throughout to primary and secondary memory modules coupled to the same memory channel, with bandwidth shared between the memory modules. While connecting two memory modules or DIMMs to the same memory channel provides one example, it will be understood that it is also possible to extend the memory channel to additional memory modules over repeated channels in accordance with what is described herein. Thus, descriptions to a primary memory module can refer to a memory module that couples to a repeated channel, and further repeats the channel to another memory module. In such an implementation, the secondary module can be a secondary module from the perspective of the upstream memory module coupled closer to the host and can be a primary module from the perspective of a downstream memory module coupled farther from the host. The secondary memory module could thus repeat the channel on another repeated channel segment.

In a practical implementation of a system in which there are two memory modules coupled to a memory channel, it may not be practical to repeat any more than half the bandwidth. Thus, the repeated segment or portion may be up to half the native channel. In accordance with an embodiment where more than two memory modules are coupled to the same memory channel, the repeated portion may be more than half the bandwidth. For example, consider an example where each of three connected memory modules is allocated a third of total bandwidth. The repeater on the first memory module could repeat 2/3 bandwidth on a repeated channel, and the repeater on the second memory module could repeat 1/3 bandwidth on a second repeated channel. The repeater logic may be more complex and the timing may be more complex in such implementations, but it will be understood that such implementation can fall within the scope of what is described herein. Thus, descriptions below with reference to first and second memory modules and a repeated channel with half the bandwidth will be understood as non-limiting examples, and system configurations with more memory modules and/or with different portions of the native memory channel repeated can also be applied to the descriptions herein.

Reference to memory devices can apply to different memory types. Memory devices generally refer to volatile memory technologies. Volatile memory is memory whose state (and therefore the data stored on it) is indeterminate if power is interrupted to the device. Nonvolatile memory refers to memory whose state is determinate even if power is interrupted to the device. Dynamic volatile memory requires refreshing the data stored in the device to maintain state. One example of dynamic volatile memory includes DRAM (dynamic random access memory), or some variant such as synchronous DRAM (SDRAM). A memory subsystem as described herein may be compatible with a number of memory technologies, such as DDR3 (dual data rate version 3, original release by JEDEC (Joint Electronic Device Engineering Council) on June 27, 2007, currently on release 21), DDR4 (DDR version 4, initial specification published in September 2012 by JEDEC), DDR4E (DDR version 4, extended, currently in discussion by JEDEC), LPDDR3 (low power DDR version 3, JESD209-3B, Aug 2013 by JEDEC), LPDDR4 (LOW POWER DOUBLE DATA RATE (LPDDR) version 4, JESD209-4, originally published by JEDEC in August 2014), WI02 (Wide I/O 2 (WideI02), JESD229-2, originally published by JEDEC in August 2014), HBM (HIGH BANDWIDTH MEMORY DRAM, JESD235, originally published by JEDEC in October 2013), DDR5 (DDR version 5, currently in discussion by JEDEC), LPDDR5 (currently in discussion by JEDEC), HBM2 (HBM version 2), (currently in discussion by JEDEC), and/or others, and technologies based on derivatives or extensions of such specifications.

In addition to, or alternatively to, volatile memory, in one embodiment, reference to memory devices can refer to a nonvolatile memory device whose state is determinate even if power is interrupted to the device. In one embodiment, the nonvolatile memory device is a block addressable memory device, such as NAND or NOR technologies. Thus, a memory device can also include a future generation nonvolatile devices, such as a three dimensional crosspoint memory device, or other byte addressable nonvolatile memory devices, or memory devices that use a chalcogenide phase change material (e.g., chalcogenide glass). In one embodiment, the memory device can be or include multi-threshold level NAND flash memory, NOR flash memory, single or multi-level Phase Change Memory (PCM), a resistive memory, nanowire memory, ferroelectric transistor random access memory (FeTRAM), magnetoresistive random access memory (MRAM) memory that incorporates memristor technology, or spin transfer torque (STT)-MRAM, or a combination of any of the above, or other memory.

Descriptions herein referring to a "DRAM" can apply to any memory device that allows random access, whether volatile or nonvolatile. The memory device or DRAM can refer to the die itself and/or to a packaged memory product.

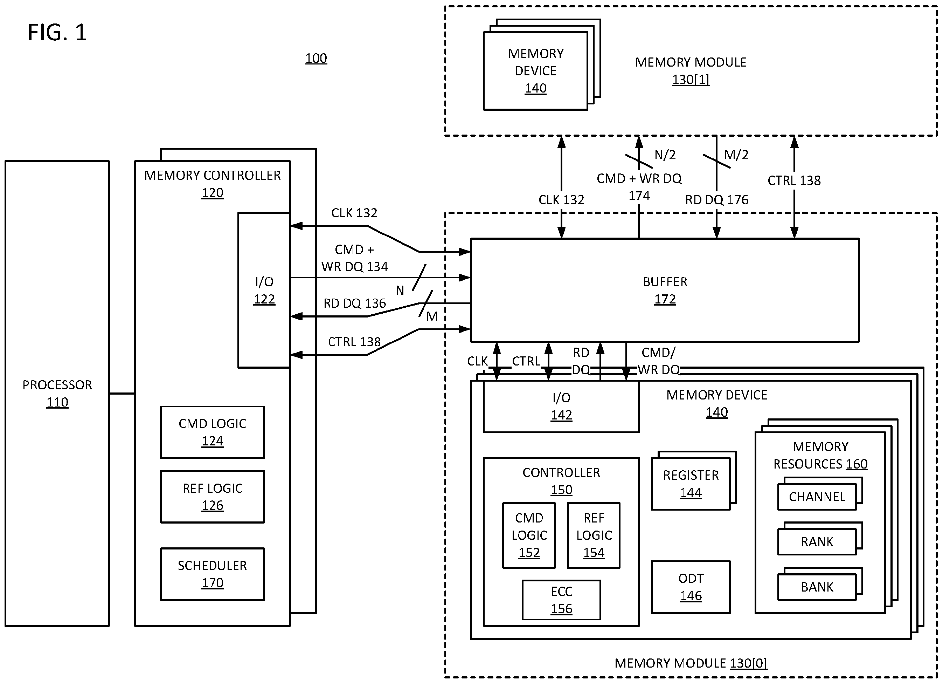

**Figure 1** is a block diagram of an embodiment of a system with a repeater channel architecture having a lower bandwidth repeater channel to extend the memory channel to another memory module. System 100 includes elements of a memory subsystem in a computing device. Processor 110 represents a processing unit of a host computing platform that executes an operating system (OS) and applications, which can collectively be referred to as a "host" for the memory. The OS and applications execute operations that result in memory accesses. Processor 110 can include one or more separate processors. Each separate processor can include a single and/or a multicore processing unit. The processing unit can be a primary processor such as a CPU (central processing unit) and/or a peripheral processor such as a GPU (graphics processing unit). System 100 can be implemented as an SOC (system on a chip), or be implemented with standalone components.

Memory controller 120 represents one or more memory controller circuits or devices for system 100. Memory controller 120 represents control logic that generates memory access commands in response to the execution of operations by processor 110. Memory controller 120 accesses one or more memory devices 140. Memory devices 140 can be DRAMs in accordance with any referred to above. In one embodiment, memory devices 140 are organized and managed as different channels, where each channel couples to buses and signal lines that couple to multiple memory devices in parallel. Each channel is independently operable. Thus, each channel is independently accessed and controlled, and the timing, data transfer, command and address exchanges, and other operations are separate for each channel. As used herein, coupling can refer to an electrical coupling, communicative, and/or a physical coupling. Physical coupling can include direct contact. Electrical coupling includes an interface or interconnection that allows electrical flow and/or signaling between components. Communicative coupling includes connections, including wireless, that enable components to exchange data.

In one embodiment, settings for each channel are controlled by separate mode registers or other register settings. In one embodiment, each memory controller 120 manages a separate memory channel, although system 100 can be configured to have multiple channels managed by a single controller, or to have multiple controllers on a single channel. In one embodiment, memory controller 120 is part of host processor 110, such as logic implemented on the same die or implemented in the same package space as the processor.

Memory controller 120 includes I/O interface logic 122 to couple to a system bus and/or a memory bus, such as a memory channel as referred to above. I/O interface logic 122 (as well as I/O interface logic 142 of memory device 140) can include pins, pads, connectors, signal lines, traces, wires, and/or other hardware to connect the devices. I/O interface logic 122 can include a hardware interface. As illustrated, I/O interface logic 122 includes at least drivers/transceivers for signal lines. Commonly, wires within an integrated circuit interface couple with a pad, pin, or connector to interface signal lines or traces or other wires between devices. I/O interface logic 122 can include drivers, receivers, transceivers, termination, and/or other circuitry to send and/or receive signal on the signal lines between the devices. The system bus can be implemented as multiple signal lines coupling memory controller 120 to memory devices 140. The system bus includes at least clock (CLK) 132, command/address (CMD) and write data (DQ) 134, read DQ 136, and zero or more other signal lines 138. In one embodiment, a bus or connection between memory controller 120 and memory can be referred to as a memory bus. The signal lines for CMD can be referred to as a "C/A bus" (or ADD/CMD bus, or some other designation indicating the transfer of commands and address information) and the signal lines for write and read DQ can be referred to as a "data bus." In one embodiment, independent channels have different clock signals, C/A buses, data buses, and other signal lines. Thus, system 100 can be considered to have multiple "system buses," in the sense that an independent interface path can be considered a separate system bus. It will be understood that in addition to the lines explicitly shown, a system bus can include strobe signaling lines, alert lines, auxiliary lines, and other signal lines.

It will be understood that the system bus includes a command and write data bus 134 configured to operate at a bandwidth. In one embodiment, the command and write signal lines can include unidirectional lines for write and command data from the host to memory, and read DQ 136 can include unidirectional lines for read data from the memory to the host. In one embodiment, the data bus can includes bidirectional lines for read data and for write/command data. Based on design and/or implementation of system 100, the data bus can have more or less bandwidth per memory device 140. For example, the data bus can support memory devices that have either a x32 interface, a x16 interface, a x8 interface, or other interface. The convention "xW," where W is a binary integer refers to an interface size of memory device 140, which represents a number of signal lines to exchange data with memory controller 120. The interface size of the memory devices is a controlling factor on how many memory devices can be used concurrently per channel in system 100 or coupled in parallel to the same signal lines.

Memory devices 140 represent memory resources for system 100. In one embodiment, each memory device 140 is a separate memory die. In one embodiment, each memory device 140 can interface with multiple (e.g., 2) channels per device or die. Each memory device 140 includes I/O interface logic 142, which has a bandwidth determined by the implementation of the device (e.g., x16 or x8 or some other interface bandwidth). I/O interface logic 142 enables the memory devices to interface with memory controller 120. I/O interface logic 142 can include a hardware interface, and can be in accordance with I/O 122 of memory controller, but at the memory device end. In one embodiment, multiple memory devices 140 are connected in parallel to the same data buses. For example, system 100 can be configured with multiple memory devices 140 coupled in parallel, with each memory device responding to a command, and accessing memory resources 160 internal to each. For a Write operation, an individual memory device 140 can write a portion of the overall data word, and for a Read operation, an individual memory device 140 can fetch a portion of the overall data word.

In one embodiment, memory devices 140 are disposed directly on a motherboard or host system platform (e.g., a PCB (printed circuit board) on which processor 110 is disposed) of a computing device. In one embodiment, memory devices 140 can be organized into memory modules 130. In one embodiment, memory modules 130 represent dual inline memory modules (DIMMs). In one embodiment, memory modules 130 represent other organization of multiple memory devices to share at least a portion of access or control circuitry, which can be a separate circuit, a separate device, or a separate board from the host system platform. Memory modules 130 can include multiple memory devices 140, and the memory modules can include support for multiple separate channels to the included memory devices disposed on them.

Memory devices 140 each include memory resources 160. Memory resources 160 represent individual arrays of memory locations or storage locations for data. Typically memory resources 160 are managed as rows of data, accessed via wordline (rows) and bitline (individual bits within a row) control. Memory resources 160 can be organized as separate channels, ranks, and banks of memory. Channels are independent control paths to storage locations within memory devices 140. Ranks refer to common locations across multiple memory devices (e.g., same row addresses within different devices). Banks refer to arrays of memory locations within a memory device 140. In one embodiment, banks of memory are divided into sub-banks with at least a portion of shared circuitry (e.g., drivers, signal lines, control logic) for the sub-banks. It will be understood that channels, ranks, banks, and/or other organizations of the memory locations can overlap physical resources. For example, the same physical memory locations can be accessed over a specific channel as a specific bank, which can also belong to a rank. Thus, the organization of memory resources will be understood in an inclusive, rather than exclusive, manner.

In one embodiment, memory devices 140 include one or more registers 144. Register 144 represents one or more storage devices or storage locations that provide configuration or settings for the operation of the memory device. In one embodiment, register 144 can provide a storage location for memory device 140 to store data for access by memory controller 120 as part of a control or management operation. In one embodiment, register 144 includes one or more Mode Registers. In one embodiment, register 144 includes one or more multipurpose registers. The configuration of locations within register 144 can configure memory device 140 to operate in different "mode," where command and/or address information or signal lines can trigger different operations within memory device 140 depending on the mode. Settings of register 144 can indicate configuration for I/O settings (e.g., timing, termination or ODT (on-die termination), driver configuration, and/or other I/O settings).

In one embodiment, memory device 140 includes ODT 146 as part of the interface hardware associated with I/O 142. ODT 146 can be configured as mentioned above, and provide settings for impedance to be applied to the interface to specified signal lines. The ODT settings can be changed based on whether a memory device is a selected target of an access operation or a non-target device. ODT 146 settings can affect the timing and reflections of signaling on the terminated lines. Careful control over ODT 146 can enable higher-speed operation with improved matching of applied impedance and loading. ODT 146 can be applied to specific signal lines of I/O interface 142, 122, and is not necessarily applied to all signal lines.

Memory device 140 includes controller 150, which represents control logic within the memory device to control internal operations within the memory device. For example, controller 150 decodes commands sent by memory controller 120 and generates internal operations to execute or satisfy the commands. Controller 150 can be referred to as an internal controller. Controller 150 can determine what mode is selected based on register 144, and configure the access and/or execution of operations for memory resources 160 based on the selected mode. Controller 150 generates control signals to control the routing of bits within memory device 140 to provide a proper interface for the selected mode and direct a command to the proper memory locations or addresses.

Referring again to memory controller 120, memory controller 120 includes command (CMD) logic 124, which represents logic or circuitry to generate commands to send to memory devices 140. Typically, the signaling in memory subsystems includes address information within or accompanying the command to indicate or select one or more memory locations where the memory devices should execute the command. In one embodiment, controller 150 of memory device 140 includes command logic 152 to receive and decode command and address information received via I/O 142 from memory controller 120. Based on the received command and address information, controller 150 can control the timing of operations of the logic and circuitry within memory device 140 to execute the commands. Controller 150 is responsible for compliance with standards or specifications within memory device 140, such as timing and signaling requirements. Memory controller 120 can also ensure compliance with standards or specifications by access scheduling and control.

In one embodiment, memory controller 120 includes refresh (REF) logic 126. Refresh logic 126 can be used where memory devices 140 are volatile and need to be refreshed to maintain a deterministic state. In one embodiment, refresh logic 126 indicates a location for refresh, and a type of refresh to perform. Refresh logic 126 can trigger self-refresh within memory device 140, and/or execute external refreshes by sending refresh commands. For example, in one embodiment, system 100 supports all bank refreshes as well as per bank refreshes, or other all bank and per bank commands. All bank commands cause an operation of a selected bank within all memory devices 140 coupled in parallel. Per bank commands cause the operation of a specified bank within a specified memory device 140. In one embodiment, controller 150 within memory device 140 includes refresh logic 154 to apply refresh within memory device 140. In one embodiment, refresh logic 154 generates internal operations to perform refresh in accordance with an external refresh received from memory controller 120. Refresh logic 154 can determine if a refresh is directed to memory device 140, and what memory resources 160 to refresh in response to the command.

In one embodiment, system 100 includes multiple memory modules 130 that include memory devices 140. In one embodiment, memory modules 130 provide a repeater architecture for a memory channel. The memory channel can include clock 132, command and write DQ 134, read DQ 136, and zero or more other control signals 138. In a repeater architecture, memory module 130[1] connects to memory controller 120 via buffer or repeater 172 of memory module 130[0]. Thus, memory module 130[0] has a point-to-point connection to memory controller 120, and memory module 130[1] has a point-to-point connection to memory module 130[0]. In the repeater architecture described herein, memory module 130[0] connects to memory controller 120 with a higher bandwidth connection than memory module 130[1]. In one embodiment, buffer 172 provides an input point for all memory channel signals from memory controller 120 to implement the point-to-point connection, and provides clock, command/write, read, and control interfaces to all memory devices 140 of memory module 130[0]. It will be understood that clock 132 and possibly other control signal lines 138 can be repeated via buffer 172. For purposes of illustration, the command and write signal lines as well as the read signal lines on the repeated channel have different reference numbers (174 and 176, respectively) to identify that the repeated channel or repeated channel portion has a lower bandwidth.

For purposes of description, the point-to-point connection from memory module 130[0] to memory controller 120 will be referred to as a primary channel or a primary connection, and the point-to-point connection from memory module 130[1] to memory module 130[0] will be referred to as a secondary channel or a secondary connection. In either case, it will be understood that memory controller 120 can treat a memory channel as having memory module 130[0] and memory module 130[1] connected to it. The timing of signaling to memory module 130[1] may be different than the timing from memory module 130[0].

As illustrated in system 100, memory module 130[0] has a native connection with memory controller 120 with N command and write DQ signal lines, and M read DQ signal lines. In one embodiment, M is greater than N, although in one embodiment M could be equal to N. Memory module 130[1] does not have a native connection with memory controller 120, and in one embodiment connects with N/2 command and write DQ signal lines 174 and M/2 read signal lines 176. It will be understood that buffer 172 includes hardware to interface the primary connection to the secondary connection. In one embodiment, buffer 172 can include software or other logic to control the connection of command and write signal lines 134 to write signal lines 174 and/or of read signal lines 136 to read signal lines 176.

With point-to-point connections, the loading on the memory channel at memory controller 120 is reduced relative to a multidrop architecture. With reduced loading, system 100 can operate the memory channel at a higher data rate than a corresponding multidrop memory channel. In an example not covered by the claims, the higher data rate can enable the use of fewer data pins to provide the same throughput. In one embodiment, the signaling timing on the repeated channel is the same as the signaling timing (e.g., the same data rate per signal line) on the primary channel. However, with a lower bandwidth connection or fewer signal lines, the overall data throughput on the repeated channel would be less than the data throughput on the primary channel due to the reduced bandwidth of the channel. The system compensates for the lower bandwidth by increasing the number of cycles (e.g., unit intervals or UIs) used to transfer the data on the primary channel. For example, data sent on N signal lines over X cycles might be sent over 2X cycles on N/2 signal lines.

Traditional memory systems included only bidirectional data channels, which allowed only a single operation on the data bus. In one embodiment, system 100 includes separate write and read data buses, including unidirectional signal lines. Such unidirectional signal lines can enable a read to be performed with one memory module 130 while a write is performed with the other memory module 130.

In one embodiment, system 100 includes a first group of signal lines to couple point-to-point as a memory channel, such as the signal lines between memory controller 120 or other host device and memory module 130[0]. Memory module 130[0] can be considered a first group of memory devices 140, referring to the memory devices on the memory module. System 100 includes a second group of signal lines to couple point-to-point between memory module 130[0] and memory module 130[1], which can be considered a second group of memory devices 140. Thus, buffer 172 can extend the memory channel to memory module 130[1], but with fewer data lines and a narrow or lower bandwidth. Buffer 172 includes a repeater that can repeat signals from the host on the first group of signal lines to the second group of signal lines, and repeat signal from the memory devices on the second group of signal lines to the host. In general, a buffer enables the point-to-point connection functionality, and provides a single instance of loading on the memory channel for multiple connected memory devices, which can include devices on a repeated channel. A repeater enables the repeating of the memory channel to another memory module and/or group of memory devices.

In one embodiment, the repeated channel from memory module 130[0] to memory module 130[1] includes half as many data signal lines as the primary channel from memory controller 120 to memory module 130[0]. In one embodiment, buffer 172 provides for approximately one half the total bandwidth of the primary channel for use by memory module 130[0], and approximately one half the total bandwidth of the primary channel to be repeated on the secondary channel for use by memory module 130[1]. In one embodiment, depending on the configuration of the primary and secondary channels, buffer 172 can provide more than half the available bandwidth to memory module 130[0], and thus use more bandwidth than memory module 130[1].

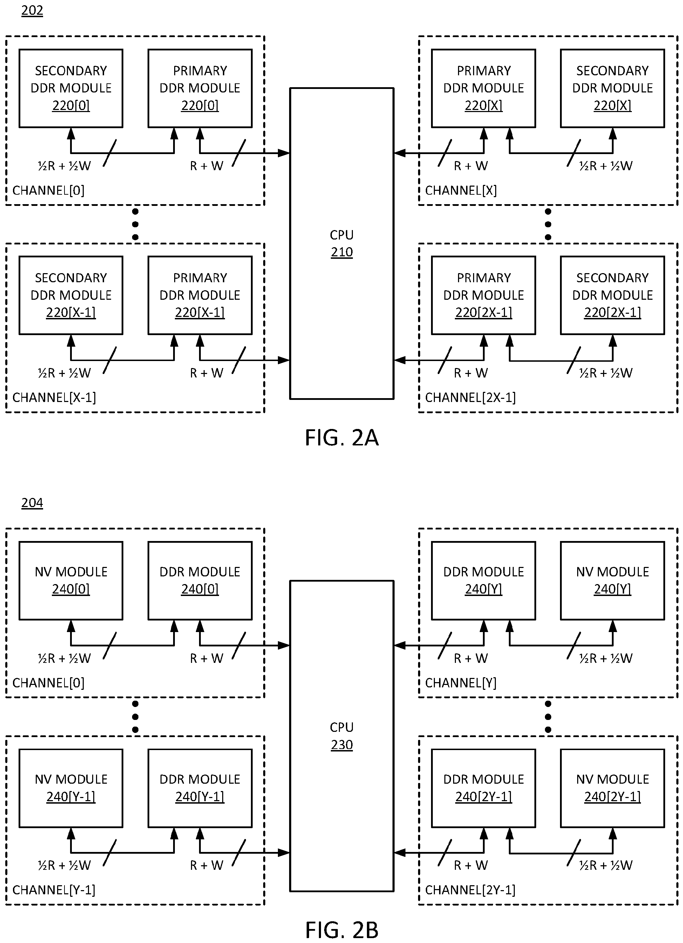

**Figure 2A** is a block diagram of an embodiment of a system with a repeater channel architecture in which dual data rate (DDR) modules occupy both primary and secondary positions on the lower bandwidth repeated channel. System 202 provides one example of a system in accordance with system 100 of Figure 1. System 202 includes central processing unit (CPU) 210, which represents a host or host device to which memory resources connect. CPU 210 includes processing resources to perform operations in system 202. CPU 210 also includes a memory controller circuit or equivalent circuitry and logic to drive commands to the memory resources and receive data from the memory resources.

As illustrated, system 202 includes 2X separate channels. In one embodiment, multiple channels connect to the same memory modules, for example in an implementation where a memory module includes memory devices configured to couple to two separate channels. The number of channels in system 202 will be an even number, for example, 2, 4, 6, 8, or some other number of channels. It will be understood that a system can be designed to use an odd number of channels in an alternate embodiment. The placement in the drawing of the channels is merely for illustration, and is not necessarily representative of a practical implementation. In one embodiment, the channels connect memory device groups organized as memory modules, such as DIMMs.

In system 202, each channel includes two memory modules, a primary memory module and a secondary memory. As illustrated, all memory modules include the same type of memory devices. In accordance with the specific example, the memory modules include DDR DRAMs. System 204 of Figure 2B includes an example with memory modules having different types of memory, as described in more detail below. Referring again to system 202, primary DDR module 220[0] couples to CPU 210 with a bandwidth of R for read data and a bandwidth of W for commands and write data. It will be understood that R and W are not necessarily equal, but they could be in one implementation. Secondary DDR module 220[0] couples to primary DDR module 220[0] with a bandwidth of R/2 for read data and a bandwidth of W/2 for commands and write data. Thus, the bandwidth for the secondary connection has half the bandwidth as the primary connection on channel[0]. The remaining channels are similar.

There are known solutions for fully buffered DIMMs that use repeaters on the DIMM. Such solutions implement a full width channel between the first DIMM and the host, as well as a full width channel between the first and second DIMMs. However, in most cases the secondary DIMM does not require a full bandwidth connection, which means the secondary connection is overprovisioned in traditional implementations. System 202 includes a narrow repeated channel. Reducing the repeated channel bandwidth can reduce the number of signal pins required on a package of CPU 210, and on corresponding connectors and PCB trace connections to the secondary DDR module. The reduction of signal pins and signal line traces results in lower silicon costs, lower power, and lower module connector pin counts.

In one embodiment, the X channels include unidirectional command and write data links and unidirectional read data links. In one embodiment, the width of the channel between the primary module and secondary module is half as wide as the channel width between CPU 210 and the primary module. In one embodiment, modules 220 include DIMMs with DRAMs or SDRAMs compliant with a DDR5 standard. In such an implementation, the primary and secondary DIMMs can each deliver approximately half of the CPU channel bandwidth as dictated by an even address distribution between the two modules. The read data link can deliver full read bandwidth from the memory modules to CPU 210. In one embodiment, CPU 210 can read from the primary DIMM simultaneously with writing data to the secondary DIMM. In one embodiment, system 202 can bias bandwidth usage towards the primary DIMM. For example, system 202 can provide up to full bandwidth (all of R and/or all of W) to the primary DIMM, and provide whatever bandwidth is requested for the secondary DIMM

**Figure 2B** is a block diagram of an embodiment of a system with a repeater channel architecture in which a dual data rate (DDR) module occupies a primary position and a nonvolatile memory occupies a secondary position on the lower bandwidth repeated channel. System 204 provides one example of a system in accordance with system 100 of Figure 1, and is an alternative to system 202 of Figure 2A. System 204 includes central processing unit (CPU) 230, which represents a host or host device to which memory resources connect. CPU 230 includes processing resources to perform operations in system 204. CPU 230 also includes a memory controller circuit or equivalent circuitry and logic to drive commands to the memory resources and receive data from the memory resources.

As illustrated, system 204 includes 2Y separate channels, where 2Y can be the same or different number as 2X. In one embodiment, multiple channels connect to the same memory modules, for example in an implementation where a memory module includes memory devices configured to couple to two separate channels. The number of channels in system 204 will be an even number, for example, 2, 4, 6, 8, or some other number of channels, but can be implemented with an odd number of channels in an alternate embodiment. In one embodiment, the channels connect memory device groups organized as memory modules, such as DIMMs.

In system 204, each channel includes two memory modules, a primary memory module and a secondary memory. Whereas in system 202 all memory modules include memory devices of the same type of technology (e.g., DDR5 DRAMs), system 204 illustrates one example of memory modules of different types connected to the same channel. For example, using channel[0] as an illustration, channel[0] includes DDR module 240[0] as the primary memory module connected to CPU 230, and NV (nonvolatile) module 240[0] as the secondary memory module connected to the primary module. In system 204, primary DDR module 240[0] couples to CPU 230 with a bandwidth of R for read data and a bandwidth of W for commands and write data. It will be understood that R and W are not necessarily equal, but they could be in one implementation. Secondary NV module 240[0] couples to primary DDR module 240[0] with a bandwidth of R/2 for read data and a bandwidth of W/2 for commands and write data. Thus, the bandwidth for the secondary connection has half the bandwidth as the primary connection on channel[0]. The remaining channels are similar.

In one embodiment, the Y channels include unidirectional command and write data links and unidirectional read data links. In one embodiment, the width of the channel between the primary module and secondary module is half as wide as the channel width between CPU 210 and the primary module. In one embodiment, primary DDR modules 240 include DIMMs with DRAMs or SDRAMs compliant with a DDR5 standard, and secondary DDR modules 240 includes DIMMs with nonvolatile, byte-addressable, random access memory devices. In one embodiment, CPU 210 can read from the primary DIMM simultaneously with writing data to the secondary DIMM. In one embodiment, system 204 can bias bandwidth usage towards the primary DIMM. For example, system 202 can provide up to full bandwidth (all of R and/or all of W) to the primary DDR memory module, and provide whatever bandwidth is needed for the DIMMs with the nonvolatile memory type.

In one embodiment, NV modules 240 include three dimensional memory devices including memory cells with a chalcogenide glass. For example, one implementation of nonvolatile memory devices includes three dimensional crosspoint (3DXP). If DDR modules 240 include DDR5 memory devices and NV modules 240 include 3DXP memory devices, the 3DXP operates more efficiently at a narrow bandwidth channel than a traditional native memory channel connection. DDR5 memory devices operate at higher speed than 3DXP and at lower power. But 3DXP operates at speeds near DDR memory, and is nonvolatile. Thus, system 204 provides both high speed, low power memory with somewhat lower speed, nonvolatile memory on the same memory channel.

In one embodiment, when DDR modules 240 include DDR5 DIMMs and NV modules 240 include 3DXP modules, system 204 shares bandwidth between the DDR5 memory and the 3DXP memory (e.g., via a buffer or repeater) on the DDR modules. In one embodiment, the DDR5 DIMM can deliver full channel bandwidth to CPU 230 when there is no 3DXP access demand. Due to the bandwidth headroom enabled by the dedicated write and read links, a significant amount of 3DXP bandwidth can be delivered to CPU 230 without reducing DDR5 bandwidth.

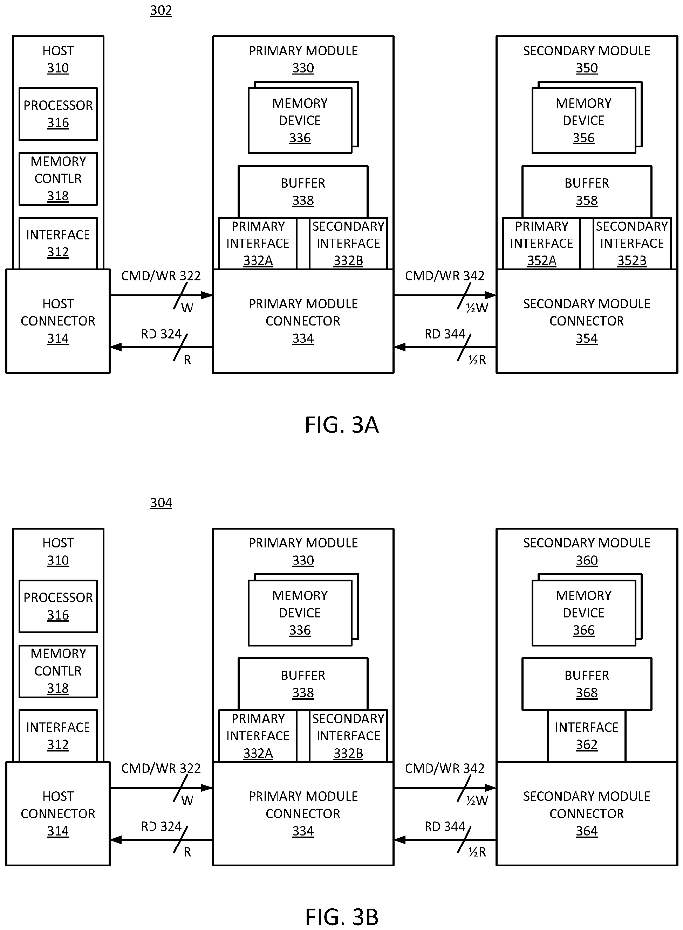

**Figure 3A** is a block diagram of an embodiment of a system with a repeater channel architecture in which both primary and secondary memory modules include a buffer. System 302 provides one example of a system in accordance with system 100, and/or systems 202 or 204. Host 310 represents logic to control operations in a system in which the memory is included. Host 310 includes processor 316, which can include one or more processing resources that generate requests for access to data stored in memory. Memory controller 318 represents hardware and logic control access to memory in response to the data needs of processor 316. In one embodiment, memory controller 318 is part of processor 316. Host 310 includes interface 312, which represents hardware such as pins, balls, pads, and/or other hardware to couple host 310 to the memory.

Host connector 314 represents hardware in system 302 to mount host 310 to a PCB or other substrate to interconnect host 310 with the memory resources of primary module 330 and secondary module 350. In one embodiment, host 310 includes discrete components coupled to mounting locations on a PCB. In one embodiment, host 310 is incorporated in an SOC that mounts into a socket, and interface 312 can provide electrical and communicative coupling to the socket connector.

Host connector 314 connects to primary module connector 334 with W command and write signal lines 322 (which can also be referred to as a command/write link) and with R read signal lines 324 (which can also be referred to as a read link). Primary module 330 couples to primary module connector 334. Primary module 330 includes memory devices 336, which can be considered a first group of memory devices. Memory devices 336 represent memory resources to be accessed by requests from host 310. In one embodiment, primary module 330 includes buffer 338, which represents logic to enable a point-to-point connection from primary module connector 334 to host connector 314, and a point-to-point connection from primary module connector 334 to secondary module connector 354. Buffer 338 includes hardware components to provide the interconnections. In one embodiment, buffer 338 includes firmware and/or software logic to provide an interconnection.

In one embodiment, buffer 338 includes primary interface 332A with a bandwidth of W command/write signal lines and R read signal lines for the primary channel connection to host 310. In one embodiment, buffer 338 includes secondary interface 332B with a bandwidth of W/2 command/write signal lines and R/2 read signal lines for the secondary channel connection to secondary module 350. Interface 332B can represent a repeater circuit of buffer 338. It will be understood that in a practical implementation of a memory subsystem, there are limitations on interconnection based on the pin counts of connectors. Thus, it would impractical with traditional systems to repeat the memory channel from primary module 330 to secondary module 350, at least because there would not be a high enough pin count available to support the connection. Thus, buffered DIMMs can repeat the signal within a DIMM, but traditionally memory channels are not repeated as point-to-point connections from one DIMM to another at least because of physical pin count limitations.

As provided in system 302, the repeated channel from primary module 330 to secondary module 350 has fewer signal lines, which can enable a point-to-point connection without having to increase the connection pin count on current industry-standard connectors. Such a repeated channel includes fewer signal lines, which reduces the bandwidth of the channel. However, the reduced bandwidth can be compensated by increasing the signaling speed on the channel.

Thus, host connector 314 connects to secondary module connector 354 via buffer 338 with W/2 command and write signal lines 342 (which can also be referred to as a command/write link) and with R/2 read signal lines 344 (which can also be referred to as a read link). Secondary module 350 includes memory devices 356, which can be considered a second group of memory devices. Memory devices 356 represent memory resources to be accessed by requests from host 310. In one embodiment, secondary module 350 includes buffer 358, which can be the same or similar to buffer 338. Thus, buffer 358 can include primary interface 352A and secondary interface 352B. In one embodiment, buffer 358 includes a repeater similar to buffer 338, which would enable buffer 358 to support a repeated channel to a next DIMM (not shown).

In the configuration of system 302, in one embodiment, a single DIMM can be manufactured that can be placed in either primary module connector 334 or in secondary module connector 354. The advantage to such an implementation is that the same type of DIMM can be connected in any available DIMM slot. Such a configuration may require the DIMM to be aware of its connection type. In one embodiment, secondary module 350 discovers that it is connected to the memory channel with W/2 signal lines for the command/write link and R/2 signal lines for the read link. In one embodiment, secondary module 350 configures internal routing and connections for use of the reduced bandwidth channel, which can include buffering read data to be sent on more UIs. Based on being connected to the lower bandwidth interface, at least some of primary interface 352A and/or secondary interface 352B will not be used by secondary module 350.

In one embodiment, a practical implementation of system 302 can include a circuit board or circuit that includes host connector 314, primary module connector 334, and secondary module connector 354. The signal lines for connection between host connector 314 and primary module connector 334, and the signal lines for connection between primary module connector 334 and secondary module connector 354 can exist in the circuit even prior to connection of host 310, primary module 330, and/or secondary module 350. Assume for a first configuration (e.g., a 1DPC (one DIMM per channel)) that host 310 and primary module 330 are connected. In such a configuration, in one embodiment, primary module 330 can utilize all bandwidth to host 310. Assume then that a user connects secondary module 350 into system 302. In such a case (e.g., a 2DPC (two DIMM per channel)), in one embodiment, buffer 338 can share the bandwidth between primary module 330 and secondary module 350 to host 310. In one embodiment, in the 2DPC configuration system 302 can generate a higher throughput to host 310 based on shared utilization of the separate command/write link and read link. For example, host 310 can coordinate a write to one module while reading from the other.

In one embodiment, careful coordination of data addresses between primary module 330 and secondary module 350 can reduce stress on the modules. For example, with proper address location striping, half of the data can be stored on primary module 330 and half of the data on secondary module 350. Greater distribution of the data results in less repeated access to a single module, which can result in lower power consumption per memory module. The lower power consumption can reduce the amount of throttling that might otherwise occur at a memory module. For example, when a threshold amount of traffic (read and/or write traffic) is focused on one module, the components tend to heat up, resulting in lower efficiency. To prevent overheating failures, a controller (not specifically shown) on the memory modules will cause throttling of data access by the host. Spreading data tends to spread the access, which can result in less stress on a single module, and therefore less throttling.

Theoretical predictions suggest peak performance with half of the total bandwidth provided to each memory module. In one embodiment, in system 302, primary module 330 utilizes approximately one half the total memory channel bandwidth, and secondary module 350 utilizes approximately one half the total memory channel bandwidth. It will be understood that the total memory channel bandwidth refers to the memory channel connection at host 310 (e.g., via host connector 314). While the total memory channel bandwidth is provided at primary module 330 at buffer 338, secondary module 350 is only presented with half the total bandwidth.

With the reduced secondary command/write link and read link, system 302 favors lower pin count for higher implementation complexity. The higher complexity comes in management of the data accesses from host 310 to the memory modules. In one embodiment, memory controller 318 manages the data access complexity, for example, by following rules for timing and access frequency to each module. In one embodiment, instead of sharing half the bandwidth for each memory module, system 302 can be configured for primary module 330 to utilize more bandwidth than secondary module 350.

**Figure 3B** is a block diagram of an embodiment of a system with a repeater channel architecture in which a primary memory module includes a buffer that supports a secondary channel, and a secondary memory module includes a buffer that does not provide a repeater function. System 304 represents an alternative to system 302. System 304 includes host 310 with processor 316, memory controller 318, and interface 312, connected to host connector 314. The descriptions of these components above can be the same as what is described above with respect to system 302. System 304 includes primary module 330 with memory devices 336, buffer 338, primary interface 332A, and secondary interface 332B, connected to primary module connector 334. The descriptions of these components above can be the same as what is described above with respect to system 302.

In one embodiment, system 304 includes secondary module 360 with memory devices 366. Secondary module 360 connects to host connector 314 via buffer 338 with W/2 command and write signal lines 342 (which can also be referred to as a command/write link) and with R/2 read signal lines 344 (which can also be referred to as a read link). Secondary module 360 includes memory devices 366, which can be considered a second group of memory devices. Memory devices 366 represent memory resources to be accessed by requests from host 310.

Secondary module 360 is different from primary module 330. Namely, secondary module 360 does not include a repeater. Buffer 368 does not repeat the connection of interface 362. Secondary module 360 includes interface 362 to couple to secondary module connector 364. In one embodiment, secondary module connection 364 is the same as secondary module connector 354 of system 302. In one embodiment, secondary module 360 is different than primary module 330 because memory devices 366 are of a different type of memory than memory devices 336. For example, secondary module 360 can be a different type of module with nonvolatile memory devices 366. In one embodiment, secondary module 360 includes the same type of memory, in that memory devices 366 and memory devices 336 are the same type of memory, and secondary module 360 is specifically designed to be mounted in a secondary position.

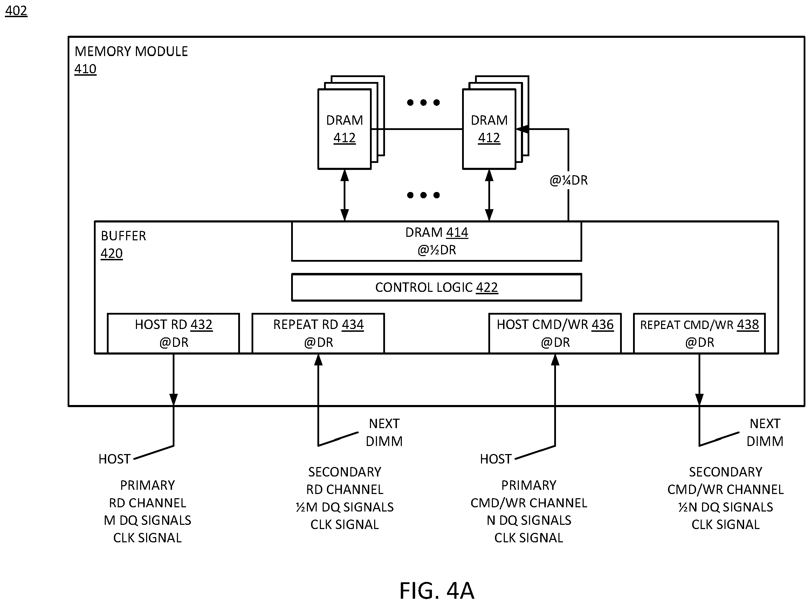

**Figure 4A** is a block diagram of an embodiment of a system with a repeater channel architecture illustrating primary and secondary channel connections for a single primary channel on a memory module. System 402 represents elements of a memory subsystem in accordance with embodiments described herein. System 402 includes memory module 410, which represents a memory module that repeats a memory channel with reduced bandwidth, in accordance with any embodiment described herein, such as a memory module of system 100, a DDR module of systems 202 or 204, or a primary module of systems 302 or 304.

In one embodiment, memory module 410 includes DRAMs 412, which represent memory device resources. The number of memory devices will be understood to vary based on the desired implementation for total capacity and density. Memory module 410 includes buffer 420, which represents a buffer and/or repeater in accordance with any embodiment described herein. Buffer 420 enables memory module 410 to repeat a memory channel to a second memory module (not specifically shown) with a lower bandwidth connection.

In one embodiment, buffer 420 includes separate read and command/write connections. Buffer 420 sends read data to the host over a primary read channel from host read interface 432. In one embodiment, host read interface 432 includes M data (DQ) signals and a clock (CLK) signal. In one embodiment, unidirectional signal lines provide the signals. In one embodiment, system 402 includes bidirectional lines to provide the signals. In one embodiment, buffer 420 receives read data from a secondary DIMM or next memory module connected on the memory channel over a secondary read channel via repeat read interface 434. In one embodiment, repeat read interface 434 includes 1/2 M data signals and the clock signal.

Buffer 420 receives command and write data from the host over a primary command/write channel at host command/write interface 436. In one embodiment, host command/write interface 436 includes N data signals and a clock signal. In one embodiment, unidirectional signal lines provide the signals. In one embodiment, system 402 includes bidirectional lines to provide the signals. In one embodiment, buffer 420 sends command/write data to the secondary DIMM or next memory module connected on the memory channel via repeat command/write interface 438. In one embodiment, repeat command/write interface 438 includes 1/2 N data signals and the clock signal.

In one embodiment, system 402 applies different data rates (DR) to different aspects of exchanging data with memory module 410. For example, interfaces 432, 434, 436, and 438 are illustrated as operating at a data rate of DR. DRAMs 412 couple to buffer 420 at DRAM interface 414. In one embodiment, buffer 420 exchanges signals with DRAMs 412 at a data rate of 1/2 DR. In one embodiment, the individual DRAMs 412 operate at a data rate of 1/4 DR. In one embodiment, buffer 420 includes hardware interface logic such as the illustrated interfaces to route or exchange data to its target. In one embodiment, buffer 420 includes controller logic 422 to control the flow of data from primary channel connections to secondary channel connections and vice versa. In one embodiment, control logic 422 includes software logic.

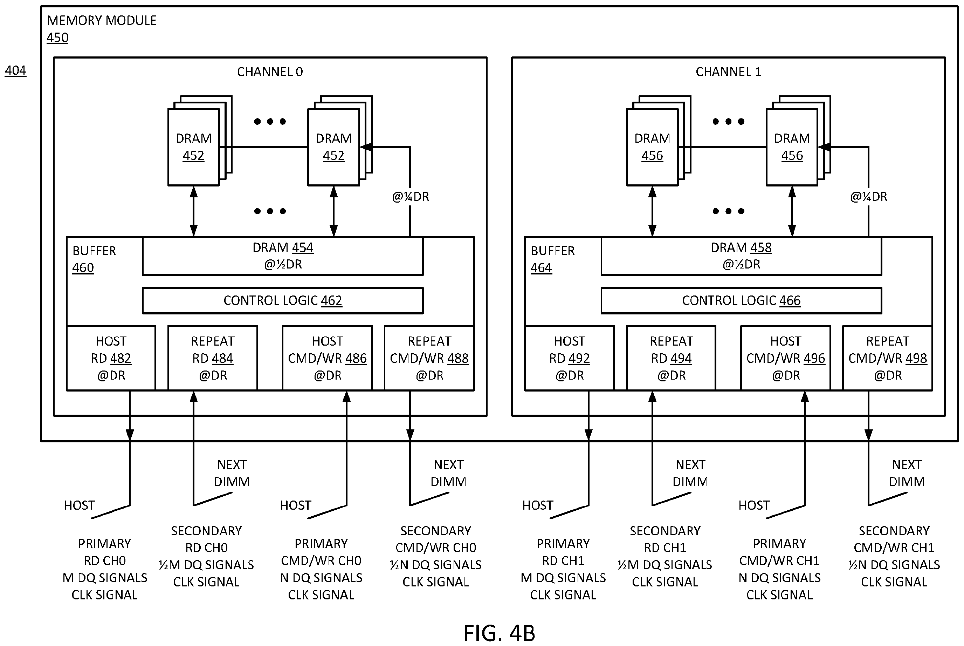

**Figure 4B** is a block diagram of an embodiment of a system with a repeater channel architecture illustrating primary and secondary channel connections for first and second channels of a memory module. System 404 represents elements of a memory subsystem in accordance with embodiments described herein. System 404 includes memory module 450, which represents a memory module that repeats a memory channel with reduced bandwidth, in accordance with any embodiment described herein.

In one embodiment, memory module 450 includes two channels, channel 0 and channel 1. Channel 0 includes DRAMs 452 and channel 1 includes DRAMs 456, which can be understood to be independent memory channels. DRAMs 452 and 456 represent memory device resources in memory module 450. The number of memory devices will be understood to vary based on the desired implementation for total capacity and density. The memory devices can be split evenly among the two channels, although such a configuration is not necessary. In one embodiment, the separate channels include separate buffers, buffer 460 for channel 0 and buffer 464 for channel 1. In one embodiment, the same buffer can service a narrow bandwidth repeated channel connection for both channels.

In one embodiment, channel 0 includes buffer 460, which can be a buffer or repeater in accordance with any embodiment described herein. Buffer 460 enables memory module 450 to repeat channel 0 from memory module 450 to a second memory module (not specifically shown) with a lower bandwidth connection. In one embodiment, channel 1 includes buffer 464, which can be a buffer and/or repeater in accordance with any embodiment described herein. Buffer 464 enables memory module 450 to repeat channel 1 from memory module 450 to a second memory module (not specifically shown) with a lower bandwidth connection, which can be the same or a different second memory module connected by repeated channel 0.

In one embodiment, buffer 460 is similar or the same as buffer 420 of system 402. In one embodiment, buffer 460 includes control logic 462 to control the flow of data between the host, memory module 450, and a "next DIMM" or additional memory module connected to the repeated channel connection. In one embodiment, buffer 460 includes host read interface 482 to send read data to the host over the primary read channel for channel 0 (CH0). In one embodiment, the primary read channel for channel 0 has M data (DQ) signals and a clock signal, and operates at a data rate of DR. In one embodiment, buffer 460 includes repeat read interface 484 to receive read data from a secondary module over the secondary read channel for channel 0. In one embodiment, the secondary read channel for channel 0 has M/2 data signals and a clock signal, and operates at a data rate of DR.

In one embodiment, buffer 460 includes host command/write (CMD/WR) interface 486 to receive commands and write data from the host over the primary command/write channel for channel 0 (CH0). In one embodiment, the primary command/write channel for channel 0 has N data signals and a clock signal, and operates at a data rate of DR. In one embodiment, buffer 460 includes repeat command/write interface 488 to send commands and write data to a secondary module over the secondary command/write channel for channel 0. In one embodiment, the secondary command/write channel for channel 0 has N/2 data signals and a clock signal, and operates at a data rate of DR.

In one embodiment, buffer 464 is similar or the same as buffer 460. In one embodiment, buffer 464 includes control logic 466 to control the flow of data between the host, memory module 450, and a "next DIMM" or additional memory module connected to the repeated channel connection. In one embodiment, buffer 464 includes host read interface 492 to send read data to the host over the primary read channel for channel 1 (CH1). In one embodiment, the primary read channel for channel 1 has M data (DQ) signals and a clock signal, and operates at a data rate of DR. In one embodiment, buffer 464 includes repeat read interface 494 to receive read data from a secondary module over the secondary read channel for channel 1. In one embodiment, the secondary read channel for channel 1 has M/2 data signals and a clock signal, and operates at a data rate of DR.

In one embodiment, buffer 464 includes host command/write (CMD/WR) interface 496 to receive commands and write data from the host over the primary command/write channel for channel 1 (CH1). In one embodiment, the primary command/write channel for channel 1 has N data signals and a clock signal, and operates at a data rate of DR. In one embodiment, buffer 464 includes repeat command/write interface 498 to send commands and write data to a secondary module over the secondary command/write channel for channel 1. In one embodiment, the secondary command/write channel for channel 1 has N/2 data signals and a clock signal, and operates at a data rate of DR.

In one embodiment, system 404 applies different data rates (DR) to different aspects of exchanging data with memory module 450. For example, external interfaces 482, 484, 486, 488, 492, 494, 496, and 498 are illustrated as operating at a data rate of DR. DRAMs 452 couple to buffer 460 at DRAM interface 454 at a data rate of 1/2 DR. In one embodiment, the individual DRAMs 452 operate at a data rate of 1/4 DR. Similarly, DRAMs 456 couple to buffer 464 at DRAM interface 458 at a data rate of 1/2 DR. In one embodiment, the individual DRAMs 456 operate at a data rate of 1/4 DR.

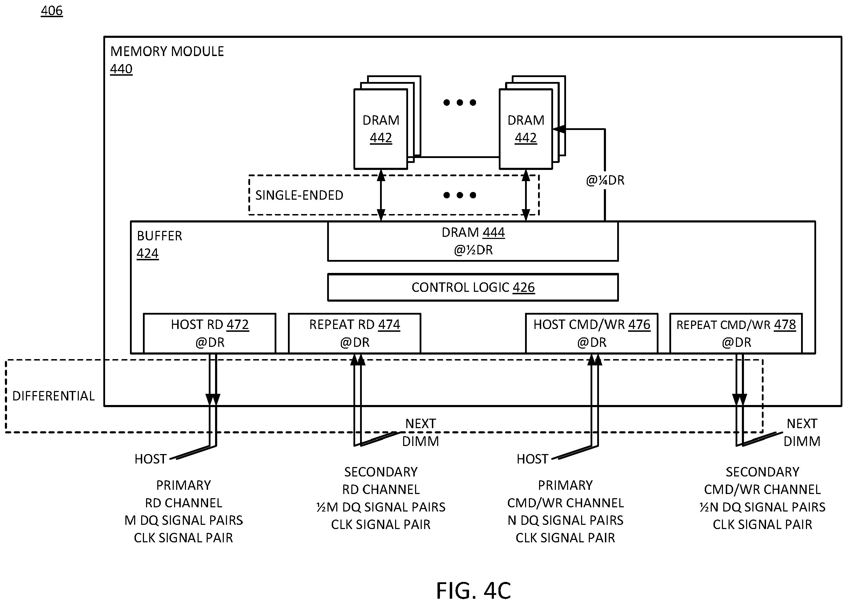

**Figure 4C** is a block diagram of an embodiment of a system with a repeater channel architecture illustrating differential signaling for the primary and secondary channel connections. System 406 represents elements of a memory subsystem in accordance with embodiments described herein. System 406 includes memory module 440, which represents a memory module that repeats a memory channel with reduced bandwidth, in accordance with any embodiment described herein, such as a memory module of system 100, a DDR module of systems 202 or 204, or a primary module of systems 302 or 304. Memory module 440 provides an example of one embodiment of a memory module in accordance with module 410 of system 402, or module 450 of system 404.

Memory module 440 more specifically illustrates differential signaling with a memory subsystem. In one embodiment, system 406 multiplexes DRAM data onto narrow high speed differential links to the host. It will be understood that differential signaling within the memory subsystem can enable further data rate increases due to the improved signal quality of differential signaling. The improvements in signal quality would be beneficial to memory access operations, but differential signaling traditionally would require too many signal lines to fit within a DIMM slot connector. However, as described herein with a point-to-point differential data link and a repeated channel having lower bandwidth, a differential implementation can be implemented with existing memory module connector pin counts.

In one embodiment, memory module 440 includes DRAMs 442, which represent memory device resources. The number of memory devices will be understood to vary based on the desired implementation for total capacity and density. Memory module 440 includes buffer 424, which represents a buffer and/or repeater in accordance with any embodiment described herein. Buffer 424 enables memory module 440 to repeat a memory channel to a second memory module (not specifically shown) with a lower bandwidth connection. Both the primary channel and the repeated or secondary channel are differential.

In one embodiment, buffer 424 includes separate read and command/write connections. Buffer 424 sends read data to the host over a primary read channel from host read interface 472, with a data rate of DR. In one embodiment, host read interface 472 includes M data (DQ) signal pairs and a clock (CLK) signal pair. In systems 402 and 404, reference is made to a number of signals, which can refer to the number of signal lines, or the number of signal pairs, depending on the implementation of those systems. In one embodiment, buffer 424 receives read data from a secondary DIMM or next memory module connected on the memory channel over a secondary read channel via repeat read interface 474, with a data rate of DR. In one embodiment, repeat read interface 474 includes 1/2 M data signal pairs and the clock signal pair.

Buffer 424 receives command and write data from the host over a primary command/write channel at host command/write interface 476, with a data rate of DR. In one embodiment, host command/write interface 476 includes N data signal pairs and a clock signal pair. In one embodiment, buffer 424 sends command/write data to the secondary DIMM or next memory module connected on the memory channel via repeat command/write interface 478, with a data rate of DR. In one embodiment, repeat command/write interface 478 includes 1/2 N data signal pairs and the clock signal pair.

In one embodiment, the outward facing interfaces of buffer 424 and memory module 440 include differential signal pairs for data. Outward facing interfaces refer to interfaces with devices external to memory module 440. Thus, connections to the host and to the next DIMM are outward facing interfaces. In one embodiment, the inward facing interfaces of buffer 424 to the DRAMs is single-ended instead of differential. Thus, for example, DRAM interface 444 includes only single-ended signal lines instead of differential signal lines to couple to DRAMs 442. In one embodiment, DRAMs 442 operate at a speed equivalent to 1/4 DR, and couple to DRAM interface 444 with a data rate of 1/2 DR. In one embodiment, buffer 424 includes hardware **i**nterface logic such as the illustrated interfaces to route or exchange data to its target. In one embodiment, buffer 424 includes controller logic 426 to control the flow of data from primary channel connections to secondary channel connections and vice versa. In one embodiment, control logic 426 includes software logic.

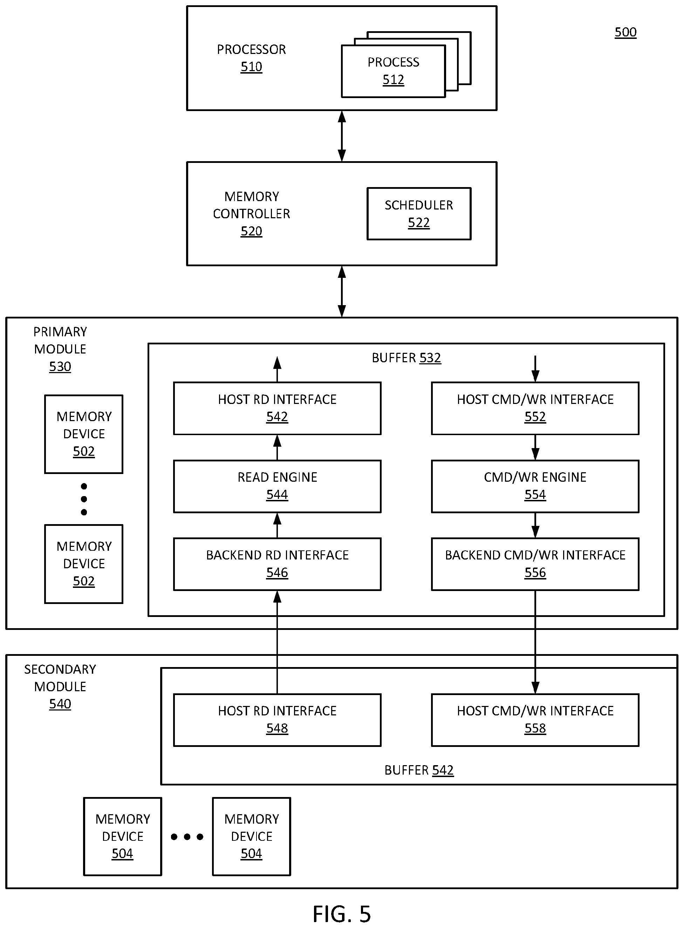

**Figure 5** is a block diagram of an embodiment of a system in which a memory controller schedules commands for a repeater channel architecture having primary and secondary channel segments of different bandwidth. System 500 represents an example of an embodiment of a system in accordance with system 100 of Figure 1. System 500 includes processor 510, which includes hardware resources to execute processes 512. Processor 510 can include one or more processing devices, which can include multicore processors. Processes 512 represent agent, threads, routines, software programs, or other software executed on processor 510. Processes 512 generate requests for data stored in memory, to read and/or to write the data.

System 500 includes memory controller 520, which can be a standalone component or integrated as a controller circuit of processor 510. Memory controller 520 controls access to memory in response to the requests for data from processes 512. Memory controller 520 includes scheduler 522, which enables memory controller 520 to schedule the timing of requests to memory. System 500 includes at least two groups of memory devices, as represented by memory devices 502 of primary module 530 and memory devices 504 of secondary module 540. Scheduler 522 manages the ordering of commands to memory devices 502 and 504. Management of the ordering of the commands enables memory controller 520 to schedule access between the two separate groups of memory devices. While illustrated as separate groups of memory devices, in one embodiment, similar techniques could be used to separately access two memory devices with point-to-point connections.

In one embodiment, primary module 530 includes buffer 532, which represents a buffer and/or repeater in accordance with any embodiment described herein. Buffer 532 receives commands and write data with host command/write interface 552. The link to host command/write interface 552 has an associated bandwidth that can be the bandwidth of a native memory channel connection. In one embodiment, secondary module 540 includes buffer 542, which represents a buffer that does not execute a repeat function. Buffer 542 receives commands and write data from primary module 530 with host command/write interface 558, with a reduced bandwidth.

In one embodiment, buffer 532 includes command/write engine 554 to manage the repeat of the memory channel that enables a point-to-point connection to secondary module 540. Buffer 532 can repeat command and write data traffic from the host to secondary module 540. Command/write engine 554 can transfer commands and write data via backend command/write interface 556, which is an interface to repeat the commands and data to secondary module 540. Backend command/write interface 556 can be referred to as a repeat interface. Backend command/write interface 556 interfaces with host command/write interface 558 of secondary module 540. In one embodiment, host command/write interface 558 is part of buffer 542, but buffer 542 of secondary module 540 does not necessarily include a repeater in the buffer.

For read traffic, host read interface 548 of secondary module 540 enables the secondary module to send read data to memory controller 520 and processor 510. In one embodiment, host read interface 548 is part of buffer 542 at secondary module 540. Host read interface 548 interfaces with backend read interface 546 of buffer 532 of primary module 530. In one embodiment, buffer 532 includes read engine 544 to manage the repeat of the memory channel that enables a point-to-point connection to secondary module 540. Buffer 532 can repeat read data traffic from secondary module 540 to the host. Read engine 544 can transfer read data via host read interface 542, which is an interface to memory controller 520 and processor 510.

In one embodiment, memory controller 520 via scheduler 522 can be configured to schedule the data access to memory devices 502 and to memory devices 504 based on the management of traffic by read engine 544 and command/write engine 554. Thus, scheduler 522 can schedule reads and writes to primary module 530 and to secondary module 540 based on expected timing to the memory devices, and available bandwidth to the modules.

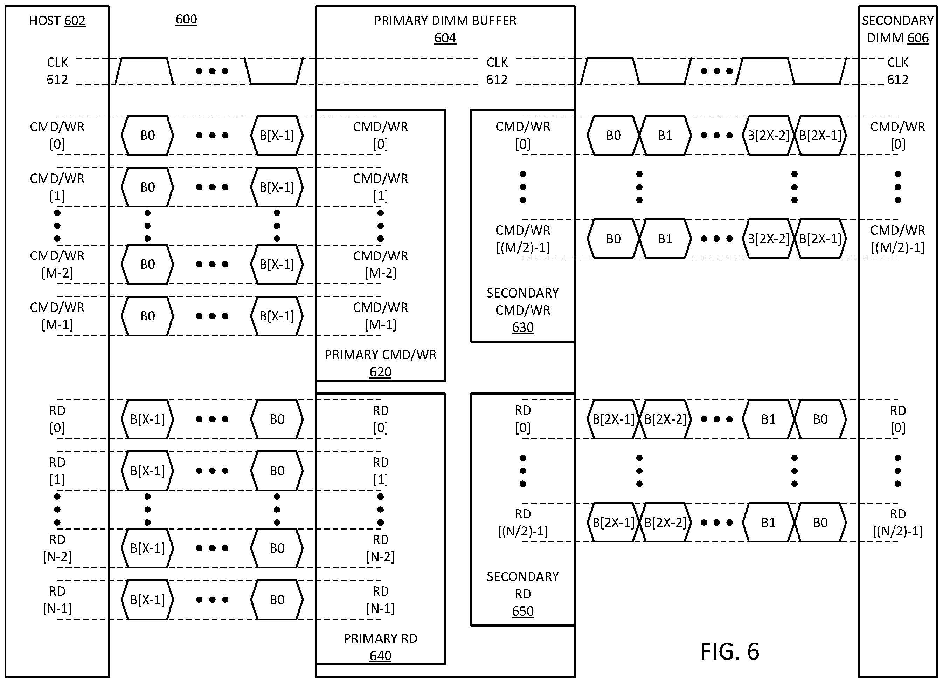

**Figure 6** is a block diagram of an embodiment of a timing representation for a repeater channel architecture in which primary and secondary channel segments have different bandwidths. System 600 includes host 602, primary DIMM buffer 604, and secondary DIMM 606. System 600 includes a representation of timing between the host, the buffer, and the second DIMM. System 600 provides one example of an embodiment of a system in accordance with system 100 of Figure 1. System 600 illustrates an embodiment of a repeated channel architecture as described herein. In the specific example of system 600, the secondary or backend channel is repeated with half the bandwidth as the primary or frontend channel. To adjust for the reduced bandwidth, the secondary channel may double the amount of time it takes to exchange data from the secondary module to the primary module.

Host 602 represents a host in accordance with any embodiment described herein, and includes at least logic to manage access to the memory. For example, host 602 can include a host processor and a memory controller circuit. Primary DIMM buffer 604 represents a buffer on a primary memory module, where the buffer provides a point-to-point connection to host 602, and provides a point-to-point connection to a next connected memory module. Secondary DIMM 606 represents the next connected memory module, which has a point-to-point connection to primary DIMM buffer 604.

As illustrated, host 602 generates clock 612 to control the timing of signaling across the memory channel. Primary DIMM buffer 604 repeats clock 612 to secondary DIMM 606. The memory devices (not specifically shown) time their operations based on clock 612, on both the primary and the secondary memory modules.

In one embodiment, system 600 includes separate read and write links. As illustrated, buffer 604 includes primary command/write interface 620 and primary read interface 640, both of which interface with host 602. Buffer 604 repeats the primary command/write channel to secondary DIMM 606 through secondary command/write interface 630, and repeats the primary read channel to secondary DIMM 606 through secondary read interface 650.

In one embodiment, primary command/write interface 620 includes M signal lines, and secondary command/write interface 630 includes M/2 signal lines. In one embodiment, primary read interface 640 includes N signal lines, and secondary read interface 650 includes N/2 signal lines. In one embodiment, the primary channel includes M command/write data signal lines and N read data signal lines, managed as independent interfaces. Similarly, the secondary channel can include M/2 command/write data signal lines and N/2 read data signal lines, managed as separate interfaces.

As illustrated, the primary channel operates over X UI, which can be referred to as a burst length (BL) for the memory access operation. For example, X can be 8 or 16 UI to transfer a sequence of 8 or 16 bits, respectively, on each signal line. Thus, a memory access operation (either read or write) includes the transfer of a total number of bits equal to the interface size times the burst length. Thus, commands and writes transfer X^{∗}M bits from host 602 to primary DIMM buffer 604. If primary DIMM buffer 604 repeats the bits to secondary DIMM 606, the transfer occurs over half as many command/write data signal lines (M/2), but over a longer burst cycle (2X). Thus, the total number of bits transferred is the same: (2X)^{∗}(M/2) = X^{∗}M.

It will be understood that system 600 illustrates the write bits as flowing from host 602 towards the memory modules, while the read bits are illustrated as flowing from the memory modules to host 602. Reads transfer X^{∗}N bits from primary DIMM buffer 604 to host 602. If a read access requests data bits from secondary DIMM 606, the transfer includes the transfer of bits over N/2 read data signal lines for 2X UI for a total number of bits equal to (2X)^{∗}(N/2) = X^{∗}N. Primary DIMM buffer 604 then repeats the X^{∗}N bits over N signal lines for X UI to transfer the X^{∗}N bits to host 602.

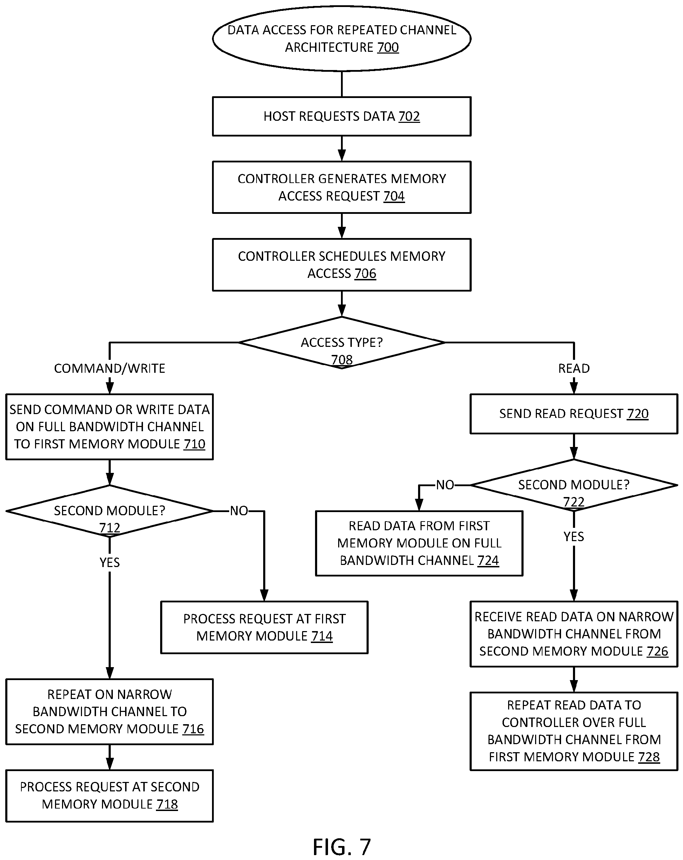

**Figure** 7 is a flow diagram of an embodiment of a process for accessing data in a repeated channel architecture with primary channel and secondary channel segments having different bandwidths. Process 700 illustrates a flow for data access in a repeated channel architecture. Process 700 provides one example of a flow in accordance with any repeated channel architecture described herein.

During operation of an electronic device, a host generates requests for data stored in memory resources coupled to a memory channel. The host can include a host processor or a peripheral processor, a host operating system (OS) that controls the hardware and software platforms of the electronic device, or a process or program operating from an application or service under the host OS. The host requests the data, 702. A memory controller or equivalent circuitry generates a memory access request to send to the memory resources over a memory channel, 704. The memory controller schedules the memory access to the memory resources, 706. In one embodiment, the memory controller schedules the access requests in light of longer access times from memory resources on a secondary memory module. In one embodiment, the scheduling can account for different repeating techniques applied by a command and write engine for sending commands and data and/or different repeating techniques applied by a read engine for receiving read data. The write engine and read engine can be applied within a buffer or repeater in the primary memory module in accordance with what is described above.

In one embodiment, the system includes separate command/write data and read data links. In one embodiment, if the access request is for command or write data, 708 COMMAND/WRITE branch, the memory controller sends the scheduled command or write data on a full bandwidth point-to-point connection to the first memory module, 710. The first memory module or the memory module coupled physically closest to the memory controller or host on the memory channel includes a buffer or repeater to extend the memory channel to a next memory module. In one embodiment, the buffer can determine if there is a second or next memory module coupled to the memory channel, 712. If there is no second module, 712 NO branch, the buffer only distributes the request to local memory resources on the memory devices of the first memory module, 714.

If there is a second memory module connected to the repeated memory channel, 712 YES branch, in one embodiment the buffer repeats the command or write data on a narrow bandwidth channel to the second memory module, 716. Thus, the repeated channel has a different bandwidth than the link to the first memory module. The second memory module can then process the request and perform the required operations in accordance with the command and/or write data, 718.

In one embodiment, if the access request is for read data, 708 READ branch, the memory controller sends the read request to the first memory module, 720. It will be understood that sending a read request is done by sending a command, but for purposes of description here, the sending of the read request is illustrated in a read branch. In a practical implementation with separate read and command/write buses, the memory controller will typically send a read request on the command/write bus, which the first memory module either processes or forwards to the second memory module. The selected module then returns the data on an appropriate read bus.

Thus, if the buffer of the first memory module determines that there is either not a second memory module connected to the memory channel or that a received read request is addressed to the first memory module instead of the second memory module, 722 NO branch, the first memory controller receives read data sent from the first memory module itself on a full bandwidth channel, 724. If the buffer determines that the read request is for a connected second memory module, the buffer forwards the request to the second memory module. The buffer subsequently receives read data on a narrow bandwidth channel from the second memory module, 726. The buffer then repeats the read data to the controller over the full bandwidth channel, 728.

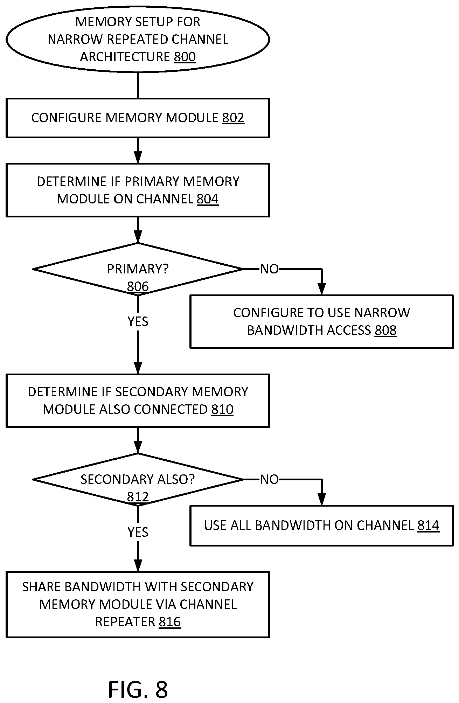

**Figure 8** is a flow diagram of an embodiment of a process for setting up a memory module in a system with a repeated channel architecture with primary channel and secondary channel segments having different bandwidths. Process 800 illustrates a flow for setting up memory for a narrow repeated channel architecture. Process 800 provides one example of a flow for a memory module in a repeated channel architecture in accordance with any embodiment described herein.

In one embodiment, the memory modules perform a discovery operation to determine where they are connected in the system. The memory modules can perform such a discovery on power up or other initialization, such as on a reset from a low power or off state, when the memory module configures itself for operation. In one embodiment, the memory module configures itself as part of a periodic configuration check. Thus, in one embodiment, a memory module configures, 802. In one embodiment, the memory module determines if it is the primary memory module on a memory channel, 804. In one embodiment, the memory controller makes the determination and sends configuration information to the memory module. In one embodiment, the memory module itself makes the determination via a handshake procedure with the memory controller.

If the memory module determines that it is not the primary memory module on the memory channel, 806 NO branch, in one embodiment the memory module configures itself for use of a narrow bandwidth interface to the memory channel, 808. For example, the memory module includes a controller (separate from the memory controller of the host) that controls the exchange of data between the memory module and the host. The controller can configure for use of more UIs to send read data, or to receive commands and write data for more UIs.

If the memory module determines that it is the primary memory module on the memory channel, 806 YES branch, in one embodiment the memory module further tries to determine if there is a secondary memory module connected to the memory channel, 810. If a secondary memory module is not also connected to the memory channel, 812 NO branch, in one embodiment the primary memory module utilizes all bandwidth of the memory channel point-to-point connection to the memory controller. If a secondary memory module is connected to the memory channel, 812 YES branch, in one embodiment the primary memory module shares bandwidth of the primary link with the secondary memory module, 816. The primary memory module shares bandwidth with the secondary module through the operation of a channel repeater in accordance with any embodiment described herein.

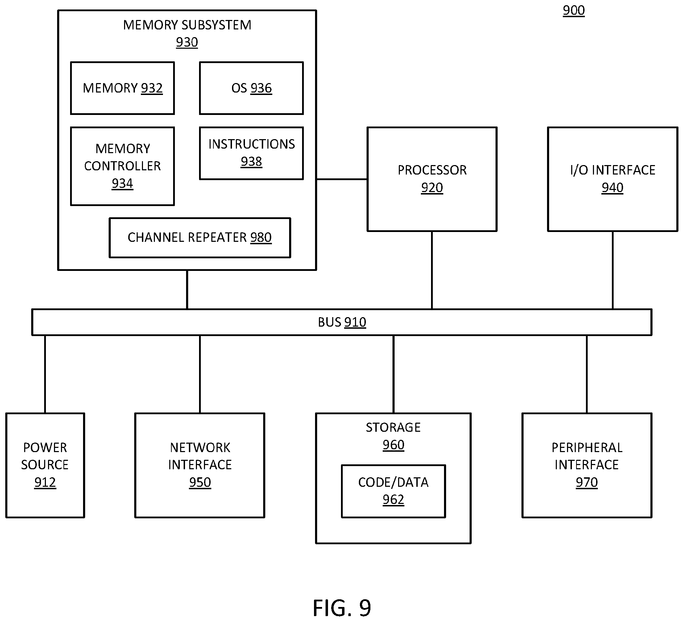

**Figure 9** is a block diagram of an embodiment of a computing system in which a repeated memory channel architecture can be implemented. System 900 represents a computing device in accordance with any embodiment described herein, and can be a laptop computer, a desktop computer, a server, a gaming or entertainment control system, a scanner, copier, printer, routing or switching device, or other electronic device. System 900 includes processor 920, which provides processing, operation management, and execution of instructions for system 900. Processor 920 can include any type of microprocessor, central processing unit (CPU), processing core, or other processing hardware to provide processing for system 900. Processor 920 controls the overall operation of system 900, and can be or include, one or more programmable general-purpose or special-purpose microprocessors, digital signal processors (DSPs), programmable controllers, application specific integrated circuits (ASICs), programmable logic devices (PLDs), or the like, or a combination of such devices. Processor 920 can execute data stored in memory 932 and/or write or edit data stored in memory 932.

Memory subsystem 930 represents the main memory of system 900, and provides temporary storage for code to be executed by processor 920, or data values to be used in executing a routine. Memory subsystem 930 can include one or more memory devices such as read-only memory (ROM), flash memory, one or more varieties of random access memory (RAM), or other memory devices, or a combination of such devices. Memory subsystem 930 stores and hosts, among other things, operating system (OS) 936 to provide a software platform for execution of instructions in system 900. Additionally, other instructions 938 are stored and executed from memory subsystem 930 to provide the logic and the processing of system 900. OS 936 and instructions 938 are executed by processor 920. Memory subsystem 930 includes memory device 932 where it stores data, instructions, programs, or other items. In one embodiment, memory subsystem includes memory controller 934, which is a memory controller to generate and issue commands to memory device 932. It will be understood that memory controller 934 could be a physical part of processor 920.

Processor 920 and memory subsystem 930 are coupled to bus/bus system 910. Bus 910 is an abstraction that represents any one or more separate physical buses, communication lines/interfaces, and/or point-to-point connections, connected by appropriate bridges, adapters, and/or controllers. Therefore, bus 910 can include, for example, one or more of a system bus, a Peripheral Component Interconnect (PCI) bus, a HyperTransport or industry standard architecture (ISA) bus, a small computer system interface (SCSI) bus, a universal serial bus (USB), or an Institute of Electrical and Electronics Engineers (IEEE) standard 1394 bus (commonly referred to as "Firewire"). The buses of bus 910 can also correspond to interfaces in network interface 950.

Power source 912 couples to bus 910 to provide power to the components of system 900. In one embodiment, power source 912 includes an AC to DC (alternating current to direct current) adapter to plug into a wall outlet. Such AC power can be renewable energy (e.g., solar power). In one embodiment, power source 912 includes only DC power, which can be provided by a DC power source, such as an external AC to DC converter. In one embodiment, power source 912 includes wireless charging hardware to charge via proximity to a charging field. In one embodiment, power source 912 can include an internal battery or fuel cell source.

System 900 also includes one or more input/output (I/O) interface(s) 940, network interface 950, one or more internal mass storage device(s) 960, and peripheral interface 970 coupled to bus 910. I/O interface 940 can include one or more interface components through which a user interacts with system 900 (e.g., video, audio, and/or alphanumeric interfacing). In one embodiment, I/O interface 940 generates a display based on data stored in memory and/or operations executed by processor 920. Network interface 950 provides system 900 the ability to communicate with remote devices (e.g., servers, other computing devices) over one or more networks. Network interface 950 can include an Ethernet adapter, wireless interconnection components, USB (universal serial bus), or other wired or wireless standards-based or proprietary interfaces. Network interface 950 can exchange data with a remote device, which can include sending data stored in memory and/or receive data to be stored in memory.

Storage 960 can be or include any conventional medium for storing large amounts of data in a nonvolatile manner, such as one or more magnetic, solid state, or optical based disks, or a combination. Storage 960 holds code or instructions and data 962 in a persistent state (i.e., the value is retained despite interruption of power to system 900). Storage 960 can be generically considered to be a "memory," although memory 930 is the executing or operating memory to provide instructions to processor 920. Whereas storage 960 is nonvolatile, memory 930 can include volatile memory (i.e., the value or state of the data is indeterminate if power is interrupted to system 900).

Peripheral interface 970 can include any hardware interface not specifically mentioned above. Peripherals refer generally to devices that connect dependently to system 900. A dependent connection is one where system 900 provides the software and/or hardware platform on which operation executes, and with which a user interacts.

In one embodiment, system 900 includes channel repeater 980. Channel repeater 980 can be implemented as a repeater and/or in a buffer on a primary memory module in accordance with any embodiment described herein. Channel repeater 980 provides a point-to-point connection for a primary connection to a host from a primary memory module or a memory module physically coupled closest to the host on a memory channel. Channel repeater 980 provides a secondary connection from the primary memory module to a secondary memory module, where the secondary connection has a lower bandwidth than the primary connection.

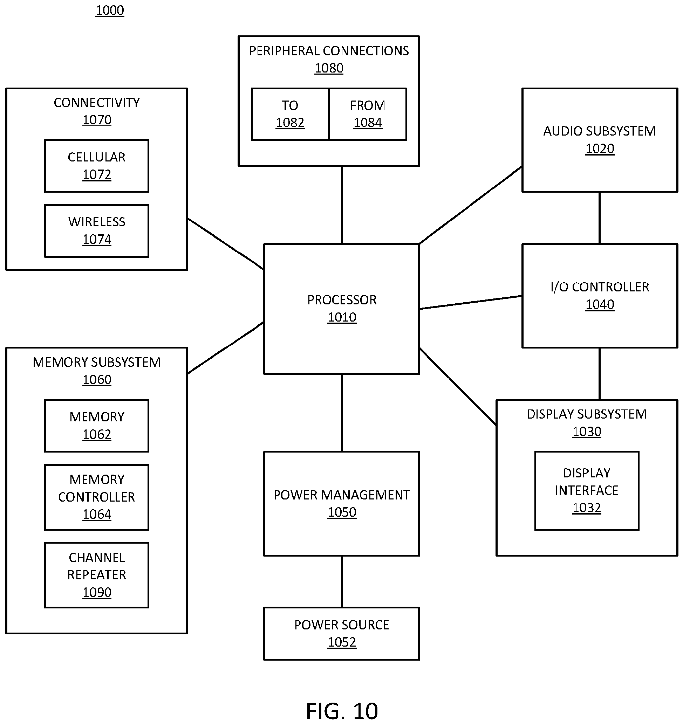

**Figure 10** is a block diagram of an embodiment of a mobile device in which a repeated memory channel architecture can be implemented. Device 1000 represents a mobile computing device, such as a computing tablet, a mobile phone or smartphone, a wireless-enabled e-reader, wearable computing device, or other mobile device. It will be understood that certain of the components are shown generally, and not all components of such a device are shown in device 1000.

Device 1000 includes processor 1010, which performs the primary processing operations of device 1000. Processor 1010 can include one or more physical devices, such as microprocessors, application processors, microcontrollers, programmable logic devices, or other processing means. The processing operations performed by processor 1010 include the execution of an operating platform or operating system on which applications and/or device functions are executed. The processing operations include operations related to I/O (input/output) with a human user or with other devices, operations related to power management, and/or operations related to connecting device 1000 to another device. The processing operations can also include operations related to audio I/O and/or display I/O. Processor 1010 can execute data stored in memory and/or write or edit data stored in memory.

In one embodiment, device 1000 includes audio subsystem 1020, which represents hardware (e.g., audio hardware and audio circuits) and software (e.g., drivers, codecs) components associated with providing audio functions to the computing device. Audio functions can include speaker and/or headphone output, as well as microphone input. Devices for such functions can be integrated into device 1000, or connected to device 1000. In one embodiment, a user interacts with device 1000 by providing audio commands that are received and processed by processor 1010.

Display subsystem 1030 represents hardware (e.g., display devices) and software (e.g., drivers) components that provide a visual and/or tactile display for a user to interact with the computing device. Display subsystem 1030 includes display interface 1032, which includes the particular screen or hardware device used to provide a display to a user. In one embodiment, display interface 1032 includes logic separate from processor 1010 to perform at least some processing related to the display. In one embodiment, display subsystem 1030 includes a touchscreen device that provides both output and input to a user. In one embodiment, display subsystem 1030 includes a high definition (HD) display that provides an output to a user. High definition can refer to a display having a pixel density of approximately 100 PPI (pixels per inch) or greater, and can include formats such as full HD (e.g., 1080p), retina displays, 4K (ultra high definition or UHD), or others. In one embodiment, display subsystem 1030 generates display information based on data stored in memory and/or operations executed by processor 1010.

I/O controller 1040 represents hardware devices and software components related to interaction with a user. I/O controller 1040 can operate to manage hardware that is part of audio subsystem 1020 and/or display subsystem 1030. Additionally, I/O controller 1040 illustrates a connection point for additional devices that connect to device 1000 through which a user might interact with the system. For example, devices that can be attached to device 1000 might include microphone devices, speaker or stereo systems, video systems or other display device, keyboard or keypad devices, or other I/O devices for use with specific applications such as card readers or other devices.

As mentioned above, I/O controller 1040 can interact with audio subsystem 1020 and/or display subsystem 1030. For example, input through a microphone or other audio device can provide input or commands for one or more applications or functions of device 1000. Additionally, audio output can be provided instead of or in addition to display output. In another example, if display subsystem includes a touchscreen, the display device also acts as an input device, which can be at least partially managed by I/O controller 1040. There can also be additional buttons or switches on device 1000 to provide I/O functions managed by I/O controller 1040.

In one embodiment, I/O controller 1040 manages devices such as accelerometers, cameras, light sensors or other environmental sensors, gyroscopes, global positioning system (GPS), or other hardware that can be included in device 1000. The input can be part of direct user interaction, as well as providing environmental input to the system to influence its operations (such as filtering for noise, adjusting displays for brightness detection, applying a flash for a camera, or other features).

In one embodiment, device 1000 includes power management 1050 that manages battery power usage, charging of the battery, and features related to power saving operation. Power management 1050 manages power from power source 1052, which provides power to the components of system 1000. In one embodiment, power source 1052 includes an AC to DC (alternating current to direct current) adapter to plug into a wall outlet. Such AC power can be renewable energy (e.g., solar power). In one embodiment, power source 1052 includes only DC power, which can be provided by a DC power source, such as an external AC to DC converter. In one embodiment, power source 1052 includes wireless charging hardware to charge via proximity to a charging field. In one embodiment, power source 1052 can include an internal battery or fuel cell source.

Memory subsystem 1060 includes memory device(s) 1062 for storing information in device 1000. Memory subsystem 1060 can include nonvolatile (state does not change if power to the memory device is interrupted) and/or volatile (state is indeterminate if power to the memory device is interrupted) memory devices. Memory 1060 can store application data, user data, music, photos, documents, or other data, as well as system data (whether long-term or temporary) related to the execution of the applications and functions of system 1000. In one embodiment, memory subsystem 1060 includes memory controller 1064 (which could also be considered part of the control of system 1000, and could potentially be considered part of processor 1010). Memory controller 1064 includes a scheduler to generate and issue commands to memory device 1062.

Connectivity 1070 includes hardware devices (e.g., wireless and/or wired connectors and communication hardware) and software components (e.g., drivers, protocol stacks) to enable device 1000 to communicate with external devices. The external device could be separate devices, such as other computing devices, wireless access points or base stations, as well as peripherals such as headsets, printers, or other devices. In one embodiment, system 1000 exchanges data with an external device for storage in memory and/or for display on a display device. The exchanged data can include data to be stored in memory and/or data already stored in memory, to read, write, or edit data.

Connectivity 1070 can include multiple different types of connectivity. To generalize, device 1000 is illustrated with cellular connectivity 1072 and wireless connectivity 1074. Cellular connectivity 1072 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, LTE (long term evolution - also referred to as "4G"), or other cellular service standards. Wireless connectivity 1074 refers to wireless connectivity that is not cellular, and can include personal area networks (such as Bluetooth), local area networks (such as WiFi), and/or wide area networks (such as WiMax), or other wireless communication. Wireless communication refers to transfer of data through the use of modulated electromagnetic radiation through a non-solid medium. Wired communication occurs through a solid communication medium.

Peripheral connections 1080 include hardware interfaces and connectors, as well as software components (e.g., drivers, protocol stacks) to make peripheral connections. It will be understood that device 1000 could both be a peripheral device ("to" 1082) to other computing devices, as well as have peripheral devices ("from" 1084) connected to it. Device 1000 commonly has a "docking" connector to connect to other computing devices for purposes such as managing (e.g., downloading and/or uploading, changing, synchronizing) content on device 1000. Additionally, a docking connector can allow device 1000 to connect to certain peripherals that allow device 1000 to control content output, for example, to audiovisual or other systems.

In addition to a proprietary docking connector or other proprietary connection hardware, device 1000 can make peripheral connections 1080 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), Firewire, or other type.

In one embodiment, system 1000 includes channel repeater 1090. Channel repeater 1090 can be implemented as a repeater and/or in a buffer on a primary memory module in accordance with any embodiment described herein. Channel repeater 1090 provides a point-to- point connection for a primary connection to a host from a primary memory module or a memory module physically coupled closest to the host on a memory channel. Channel repeater 1090 provides a secondary connection from the primary memory module to a secondary memory module, where the secondary connection has a lower bandwidth than the primary connection.

Flow diagrams as illustrated herein provide examples of sequences of various process actions. The flow diagrams can indicate operations to be executed by a software or firmware routine, as well as physical operations. In one embodiment, a flow diagram can illustrate the state of a finite state machine (FSM), which can be implemented in hardware and/or software.

To the extent various operations or functions are described herein, they can be described or defined as software code, instructions, configuration, and/or data. The content can be directly executable ("object" or "executable" form), source code, or difference code ("delta" or "patch" code). The software content of the embodiments described herein can be provided via an article of manufacture with the content stored thereon, or via a method of operating a communication interface to send data via the communication interface. A machine readable storage medium can cause a machine to perform the functions or operations described, and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each controlling component described herein includes software, hardware, or a combination of these. The controlling components can be implemented as software modules, hardware modules, special-purpose hardware (e.g., application specific hardware, application specific integrated circuits (ASICs), digital signal processors (DSPs), etc.), embedded controllers, hardwired circuitry, etc.

## Claims

1. A memory circuit to couple multiple memory devices to a memory channel, comprising:
a first and second group of memory devices (140) constituting the multiple memory devices;
a first group of signal lines (134, 136) of the memory channel configured to couple point-to-point the first group of memory devices (140) to a host device (120);
a second group of signal lines (174, 176) of the memory channel configured to couple point-to-point the first group of memory devices (140) to the second group of memory devices (140) to extend the memory channel to the second group of memory devices (140), wherein the second group of signal lines (174, 176) includes fewer data signal lines than the first group of signal lines (134, 136), to support a lower bandwidth than the first group of signal lines (134, 136) on the memory channel; and
a repeater coupled to repeat signals on the memory channel between the first group of signal lines (134, 136) and the second group of signal lines (174, 176),
**characterized in that** the repeater is configured to send data on the second group of signal lines (174, 176) over a number of cycles which is higher than the number of cycles used to transfer said data on the first group of signal lines (134, 136) in order to compensate for the lower bandwidth supported by the second group of signal lines (174, 176).

2. The memory circuit of claim 1, wherein the first group of signal lines (134, 136) and the second group of signal lines (174, 176) comprises single ended data signal lines.

3. The memory circuit of claim 1, wherein the first group of signal lines (134, 136) and the second group of signal lines (174, 176) comprises differential data signal lines.

4. The memory circuit of any of claims 1 to 3, wherein the second group of signal lines (174, 176) includes half as many data signal lines as the first group of signal lines (134, 136).

5. The memory circuit of any of claims 1 to 4, wherein the first group of memory devices (140) is to utilize approximately one half total bandwidth of the memory channel and the second group of memory devices (140) is to utilize approximately one half total bandwidth of the memory channel.

6. The memory circuit of any of claims 1 to 4, wherein the first group of memory devices (140) is to utilize more bandwidth than the second group of memory devices (140).

7. The memory circuit of any of claims 1 to 6, wherein the memory circuit comprises a first memory module (130[0]) and a second memory module (130[1]), the first group of memory devices (140) comprising memory devices of the first memory module (130[0]), and the second group of memory devices (140) comprising memory devices of the second memory module (130[1]).

8. The memory circuit of claim 7, wherein the first memory module (130[0]) comprises a dual inline memory module (DIMM) including synchronous dynamic random access memory (SDRAM) devices compliant with a dual data rate version 5 (DDR5) standard, and the second memory module (130[1]) comprises a DIMM including SDRAM devices compliant with a dual data rate version 5 (DDR5) standard.

9. The memory circuit of claim 7, wherein the first memory module (130[0]) comprises a dual inline memory module (DIMM) including synchronous dynamic random access memory (SDRAM) devices compliant with a dual data rate version 5 (DDR5) standard, and the second memory module (130[1]) comprises a DIMM including byte-addressable, random access nonvolatile memory devices.

10. The memory circuit of claim 9, wherein the byte-addressable, random access nonvolatile memory devices comprise three dimensional memory devices including memory cells with chalcogenide glass.

11. The memory circuit of any of claims 1 to 10, wherein the first group of memory devices comprises (140) a first memory module (130[0]), and wherein the second group of memory devices (140) comprises a second memory module (130[1]), and further comprising a memory controller circuit (520) coupled to control access to the memory devices (140).

12. A method for accessing multiple memory devices on a memory channel, comprising:
receiving a memory access signal on a first group of signal lines (134, 136) of the memory channel, the first group of signal lines (134, 136) coupling point-to-point a first group of memory devices (140) of the multiple memory devices to a host device (120); and
repeating at least a portion of the memory access signal on a second group of signal lines (174, 176) of the memory channel to couple point-to-point the first group of signal lines (134, 136) to a second group of memory devices (140) of the multiple memory devices to extend the memory channel to the second group of memory devices (140); and
wherein the second group of signal lines (174, 176) includes fewer data signal lines than the first group of signal lines (134, 136), to support a lower bandwidth than the first group of signal lines (134, 136) on the memory channel,
**characterized in that** the lower bandwidth supported by the second group of signal lines (174, 176) is compensated by sending data on the second group of signal lines (174, 176) over a number of cycles which is higher than the number of cycles used to transfer said data on the first group of signal lines (134, 136).

13. The method of claim 12, wherein the first group of signal lines (134, 136) and the second group of signal lines (174, 176) comprises either single ended data signal lines or differential data signal lines.

14. The method of any of claims 12 to 13, further comprising allocating approximately one half total bandwidth of the memory channel to the first group of memory devices (140) and allocating approximately one half total bandwidth of the memory channel to the second group of memory devices (140).

15. The method of any of claims 12 to 13, further comprising allocating more than one half total bandwidth of the memory channel to the first group of memory devices (140).

## Patentansprüche

1. Speicherschaltung, um mehrere Speichervorrichtungen mit einem Speicherkanal zu koppeln, umfassend:
eine erste und eine zweite Gruppe von Speichervorrichtungen (140), die die mehreren Speichervorrichtungen bilden;
eine erste Gruppe von Signalleitungen (134, 136) des Speicherkanals, die dazu ausgelegt sind, die erste Gruppe von Speichervorrichtungen (140) mit einer Hostvorrichtung (120) Punkt-zu-Punkt zu koppeln;
eine zweite Gruppe von Signalleitungen (174, 176) des Speicherkanals, die dazu ausgelegt ist, die erste Gruppe von Speichervorrichtungen (140) mit der zweiten Gruppe von Speichervorrichtungen (140) Punkt-zu-Punkt zu koppeln, um den Speicherkanal zu der zweiten Gruppe von Speichervorrichtungen (140) zu erweitern, wobei die zweite Gruppe von Signalleitungen (174, 176) weniger Datensignalleitungen als die erste Gruppe von Signalleitungen (134, 136) enthält, um eine geringere Bandbreite als die erste Gruppe von Signalleitungen (134, 136) auf dem Speicherkanal zu unterstützen; und
einen Repeater, der gekoppelt ist, um Signale auf dem Speicherkanal zwischen der ersten Gruppe von Signalleitungen (134, 136) und der zweiten Gruppe von Signalleitungen (174, 176) zu wiederholen,
**dadurch gekennzeichnet, dass** der Repeater dazu ausgelegt ist, Daten auf der zweiten Gruppe von Signalleitungen (174, 176) über eine Anzahl von Zyklen zu senden, die höher ist als die Anzahl von Zyklen, die verwendet werden, um die Daten auf der ersten Gruppe von Signalleitungen (134, 136) zu übertragen, um die geringere Bandbreite zu kompensieren, die von der zweiten Gruppe von Signalleitungen (174, 176) unterstützt wird.

2. Speicherschaltung nach Anspruch 1, wobei die erste Gruppe von Signalleitungen (134, 136) und die zweite Gruppe von Signalleitungen (174, 176) einseitige Datensignalleitungen umfasst.

3. Speicherschaltung nach Anspruch 1, wobei die erste Gruppe von Signalleitungen (134, 136) und die zweite Gruppe von Signalleitungen (174, 176) differenzielle Datensignalleitungen umfasst.

4. Speicherschaltung nach einem der Ansprüche 1 bis 3, wobei die zweite Gruppe von Signalleitungen (174, 176) halb so viele Datensignalleitungen enthält wie die erste Gruppe von Signalleitungen (134, 136).

5. Speicherschaltung nach einem der Ansprüche 1 bis 4, wobei die erste Gruppe von Speichervorrichtungen (140) etwa die halbe Gesamtbandbreite des Speicherkanals nutzen und die zweite Gruppe von Speichervorrichtungen (140) etwa die halbe Gesamtbandbreite des Speicherkanals nutzen soll.

6. Speicherschaltung nach einem der Ansprüche 1 bis 4, wobei die erste Gruppe von Speichervorrichtungen (140) mehr Bandbreite nutzen soll als die zweite Gruppe von Speichervorrichtungen (140).

7. Speicherschaltung nach einem der Ansprüche 1 bis 6, wobei die Speicherschaltung ein erstes Speichermodul (130[0]) und ein zweites Speichermodul (130[1]) umfasst, wobei die erste Gruppe von Speichervorrichtungen (140) Speichervorrichtungen des ersten Speichermoduls (130[0]) umfasst, und die zweite Gruppe von Speichervorrichtungen (140) Speichervorrichtungen des zweiten Speichermoduls (130[1]) umfasst.

8. Speicherschaltung nach Anspruch 7, wobei das erste Speichermodul (130[0]) ein Dual-in-Line-Speichermodul (DIMM) umfasst, das synchrone dynamische Direktzugriffsspeicher (SDRAM)-Vorrichtungen enthält, die dem Standard Dual Data Rate Version 5 (DDR5) entsprechen, und das zweite Speichermodul (130[1]) ein DIMM umfasst, das SDRAM-Vorrichtungen enthält, die dem Standard Dual Data Rate Version 5 (DDR5) entsprechen.

9. Speicherschaltung nach Anspruch 7, wobei das erste Speichermodul (130[0]) ein Dual-in-Line-Speichermodul (DIMM) umfasst, das synchrone dynamische Direktzugriffsspeicher (SDRAM)-Vorrichtungen enthält, die dem Standard Dual Data Rate Version 5 (DDR5) entsprechen, und das zweite Speichermodul (130[1]) ein DIMM umfasst, das byteadressierbare nichtflüchtige Direktzugriffsspeicher-Vorrichtungen enthält.

10. Speicherschaltung nach Anspruch 9, wobei die byteadressierbaren, nichtflüchtigen Direktzugriffs-Speichervorrichtungen dreidimensionale Speichervorrichtungen umfassen, die Speicherzellen mit Chalkogenidglas enthalten.

11. Speicherschaltung nach einem der Ansprüche 1 bis 10, wobei die erste Gruppe von Speichervorrichtungen ein erstes Speichermodul (130[0]) umfasst (140), und wobei die zweite Gruppe von Speichervorrichtungen (140) ein zweites Speichermodul (130[1]) umfasst, und ferner eine Speichersteuerungsschaltung (520) umfasst, die gekoppelt ist, um den Zugriff auf die Speichervorrichtungen (140) zu steuern.

12. Verfahren zum Zugreifen auf mehrere Speichervorrichtungen auf einem Speicherkanal, umfassend:
Empfangen eines Speicherzugriffssignals auf einer ersten Gruppe von Signalleitungen (134, 136) des Speicherkanals, wobei die erste Gruppe von Signalleitungen (134, 136) eine erste Gruppe von Speichervorrichtungen (140) der mehreren Speichervorrichtungen Punkt-zu-Punkt mit einer Hostvorrichtung (120) koppelt; und
Wiederholen mindestens eines Teils des Speicherzugriffssignals auf einer zweiten Gruppe von Signalleitungen (174, 176) des Speicherkanals, um die erste Gruppe von Signalleitungen (134, 136) Punkt-zu-Punkt mit einer zweiten Gruppe von Speichervorrichtungen (140) der mehreren Speichervorrichtungen zu koppeln, um den Speicherkanal zu der zweiten Gruppe von Speichervorrichtungen (140) zu erweitern; und
wobei die zweite Gruppe von Signalleitungen (174, 176) weniger Datensignalleitungen als die erste Gruppe von Signalleitungen (134, 136) enthält, um eine geringere Bandbreite als die erste Gruppe von Signalleitungen (134, 136) auf dem Speicherkanal zu unterstützen,
**dadurch gekennzeichnet, dass** die geringere Bandbreite, die von der zweiten Gruppe von Signalleitungen (174, 176) unterstützt wird, durch Senden von Daten auf der zweiten Gruppe von Signalleitungen (174, 176) über eine Anzahl von Zyklen kompensiert wird, die höher ist als die Anzahl von Zyklen, die verwendet werden, um die Daten auf der ersten Gruppe von Signalleitungen (134, 136) zu übertragen.

13. Verfahren nach Anspruch 12, wobei die erste Gruppe von Signalleitungen (134, 136) und die zweite Gruppe von Signalleitungen (174, 176) entweder einseitige Datensignalleitungen oder differenzielle Datensignalleitungen umfassen.

14. Verfahren nach einem der Ansprüche 12 bis 13, ferner umfassend das Zuweisen von etwa der Hälfte der Gesamtbandbreite des Speicherkanals an die erste Gruppe von Speichervorrichtungen (140) und das Zuweisen von etwa der Hälfte der Gesamtbandbreite des Speicherkanals an die zweite Gruppe von Speichervorrichtungen (140).

15. Verfahren nach einem der Ansprüche 12 bis 13, ferner umfassend das Zuweisen von mehr als der halben Gesamtbandbreite des Speicherkanals an die erste Gruppe von Speichervorrichtungen (140).

## Revendications

1. Circuit de mémoire pour coupler de multiples dispositifs de mémoire à un canal de mémoire, le circuit comprenant :
des premier et second groupes de dispositifs de mémoire (140) constituant les dispositifs de mémoire multiples ;
un premier groupe de lignes de signaux (134, 136) du canal de mémoire configuré pour coupler point à point le premier groupe de dispositifs de mémoire (140) à un dispositif hôte (120) ;
un second groupe de lignes de signaux (174, 176) du canal de mémoire configuré pour coupler point à point le premier groupe de dispositifs de mémoire (140) au second groupe de dispositifs de mémoire (140) pour étendre le canal de mémoire au second groupe de dispositifs de mémoire (140), où le second groupe de lignes de signaux (174, 176) comprend moins de lignes de signaux de données que le premier groupe de lignes de signaux (134, 136), pour supporter une largeur de bande inférieure à celle du premier groupe de lignes de signaux (134, 136) sur le canal de mémoire ; et
un répéteur couplé pour répéter les signaux sur le canal de mémoire entre le premier groupe de lignes de signaux (134, 136) et le second groupe de lignes de signaux (174, 176),
**caractérisé en ce que** le répéteur est configuré pour envoyer des données sur le second groupe de lignes de signaux (174, 176) sur un nombre de cycles qui est supérieur au nombre de cycles utilisés pour transférer lesdites données sur le premier groupe de lignes de signaux (134, 136) afin de compenser la largeur de bande inférieure supportée par le second groupe de lignes de signaux (174, 176).

2. Circuit de mémoire selon la revendication 1, dans lequel le premier groupe de lignes de signaux (134, 136) et le second groupe de lignes de signaux (174, 176) comprennent des lignes de signaux de données à extrémité unique.

3. Circuit de mémoire selon la revendication 1, dans lequel le premier groupe de lignes de signaux (134, 136) et le second groupe de lignes de signaux (174, 176) comprennent des lignes de signaux de données différentielles.

4. Circuit de mémoire selon l'une quelconque des revendications 1 à 3, dans lequel le second groupe de lignes de signaux (174, 176) comprend la moitié du nombre de lignes de signaux de données par rapport au premier groupe de lignes de signaux (134, 136).

5. Circuit de mémoire selon l'une quelconque des revendications 1 à 4, dans lequel le premier groupe de dispositifs de mémoire (140) doit utiliser environ la moitié de la largeur de bande totale du canal de mémoire et le second groupe de dispositifs de mémoire (140) doit utiliser environ la moitié de la largeur de bande totale du canal de mémoire.

6. Circuit de mémoire selon l'une quelconque des revendications 1 à 4, dans lequel le premier groupe de dispositifs de mémoire (140) doit utiliser plus de bande passante que le second groupe de dispositifs de mémoire (140).

7. Circuit de mémoire selon l'une quelconque des revendications 1 à 6, dans lequel le circuit de mémoire comprend un premier module de mémoire (130[0]) et un second module de mémoire (130[1]), le premier groupe de dispositifs de mémoire (140) comprenant des dispositifs de mémoire du premier module de mémoire (130[0]), et le second groupe de dispositifs de mémoire (140) comprenant des dispositifs de mémoire du second module de mémoire (130[1]).

8. Circuit de mémoire selon la revendication 7, dans lequel le premier module de mémoire (130[0]) comprend un module de mémoire double en ligne (DIMM) comprenant des dispositifs de mémoire vive dynamique synchrone (SDRAM) conformes à une norme de débit de données double, version 5 (DDR5), et le second module de mémoire (130[1]) comprend un DIMM comprenant des dispositifs SDRAM conformes à une norme de débit de données double, version 5 (DDR5).

9. Circuit de mémoire selon la revendication 7, dans lequel le premier module de mémoire (130[0]) comprend un module de mémoire double en ligne (DIMM) comprenant des dispositifs de mémoire vive dynamique synchrone (SDRAM) conformes à une norme de débit de données double, version 5 (DDR5), et le second module de mémoire (130[1]) comprend un DIMM comprenant des dispositifs de mémoire non volatile à accès aléatoire adressables par octet.

10. Circuit de mémoire selon la revendication 9, dans lequel les dispositifs de mémoire non volatile à accès aléatoire adressables par octet comprennent des dispositifs de mémoire tridimensionnels comprenant des cellules de mémoire à verre de chalcogénure.

11. Circuit de mémoire selon l'une quelconque des revendications 1 à 10, dans lequel le premier groupe de dispositifs de mémoire (140) comprend un premier module de mémoire (130[0]), et dans lequel le second groupe de dispositifs de mémoire (140) comprend un second module de mémoire (130[1]), et comprenant en outre un circuit contrôleur de mémoire (520) couplé pour contrôler l'accès aux dispositifs de mémoire (140).

12. Procédé d'accès à de multiples dispositifs de mémoire sur un canal de mémoire, le procédé comprenant les étapes suivantes :
recevoir un signal d'accès à la mémoire sur un premier groupe de lignes de signaux (134, 136) du canal de mémoire, le premier groupe de lignes de signaux (134, 136) couplant point à point un premier groupe de dispositifs de mémoire (140) des multiples dispositifs de mémoire à un dispositif hôte (120) ; et
répéter au moins une partie du signal d'accès à la mémoire sur un second groupe de lignes de signaux (174, 176) du canal de mémoire pour coupler point à point le premier groupe de lignes de signaux (134, 136) à un second groupe de dispositifs de mémoire (140) des multiples dispositifs de mémoire pour étendre le canal de mémoire au second groupe de dispositifs de mémoire (140) ; et
où le second groupe de lignes de signaux (174, 176) comprend moins de lignes de signaux de données que le premier groupe de lignes de signaux (134, 136), pour supporter une bande passante inférieure à celle du premier groupe de lignes de signaux (134, 136) sur le canal de mémoire,
**caractérisé en ce que** la largeur de bande inférieure supportée par le second groupe de lignes de signaux (174, 176) est compensée en envoyant des données sur le second groupe de lignes de signaux (174, 176) sur un nombre de cycles qui est supérieur au nombre de cycles utilisés pour transférer lesdites données sur le premier groupe de lignes de signaux (134, 136).

13. Procédé selon la revendication 12, dans lequel le premier groupe de lignes de signaux (134, 136) et le second groupe de lignes de signaux (174, 176) comprennent soit des lignes de signaux de données à extrémité unique, soit des lignes de signaux de données différentielles.

14. Procédé selon l'une quelconque des revendications 12 à 13, comprenant en outre d'attribuer environ une moitié de la largeur de bande totale du canal de mémoire au premier groupe de dispositifs de mémoire (140) et d'attribuer environ une moitié de la largeur de bande totale du canal de mémoire au second groupe de dispositifs de mémoire (140).

15. Procédé selon l'une quelconque des revendications 12 à 13, comprenant en outre d'attribuer plus de la moitié de la largeur de bande totale du canal de mémoire au premier groupe de dispositifs de mémoire (140) .
